# EUROPÄISCHE PATENTSCHRIFT

(11) **EP 3 777 482 B1**
(45) Veröffentlichungstag und Bekanntmachung des Hinweises auf die Patenterteilung: **28.02.2024**
(21) Anmeldenummer: 19716129.2
(22) Anmeldetag: 03.04.2019
(51) Int. Cl.: H05B 45/46, H05B 45/50

(54) **MEHRKANAL-LED-TREIBERVORRICHTUNG FÜR MEHRERE LED-MODULE SOWIE VERFAHREN ZUM BETREIBEN EINER MEHRKANAL-LED-TREIBERVORRICHTUNG**
MULTICHANNEL LED DRIVER DEVICE FOR A PLURALITY OF LED MODULES, AND METHOD FOR OPERATING A MULTICHANNEL LED DRIVER DEVICE
DISPOSITIF MULTICANAL DE PILOTAGE DE LED POUR PLUSIEURS MODULES LED AINSI QUE PROCÉDÉ POUR FAIRE FONCTIONNER UN DISPOSITIF MULTICANAL DE PILOTAGE DE LED

(30) Priorität: 12.04.2018 DE 102018205589
(43) Veröffentlichungstag der Anmeldung: 17.02.2021
(73) Patentinhaber: Tridonic GmbH & Co. KG, 6851 Dornbirn (AT)
(72) Erfinder: GSTIR, Sascha, 6923 Lauterach (AT); KUCERA, Clemens, 6700 Bludenz (AT); LOCHMANN, Frank, 88147 Achberg (DE); MARTE, Patrick, 6840 Götzis (AT); MAYRHOFER, Markus, 6850 Dornbirn (AT); NESENSOHN, Christian, 6840 Götzis (AT); NETZER, Harald, 6710 Nenzing (AT); WYNNYCZENKO, Oliver, 6890 Lustenau (AT); REIMONDEZ, David, 6850 Dornbirn (AT)
(74) Vertreter: Kraus & Lederer PartGmbB
(86) Internationale Anmeldenummer: PCT/EP2019/058411
(87) Internationale Veröffentlichungsnummer: WO 2019/197245

(56) Entgegenhaltungen:
- EP-A1- 2 947 965
- EP-A2- 1 858 304
- WO-A1-2009/062552
- WO-A1-2010/108580
- DE-A1-102015 118 414
- DE-A1-102015 210 189
- DE-A1-102016 109 487

## Beschreibung

### GEBIET DER ERFINDUNG

Die Erfindung liegt auf dem Gebiet der Beleuchtungstechnik und betrifft insbesondere eine Mehrkanal-LED-Treibervorrichtung, ein Verfahren zum Betreiben einer Mehrkanal-LED-Treibervorrichtung, ein entsprechendes Computerprogrammprodukt, eine Betriebsvorrichtung zum Betreiben mehrerer LED-Module sowie ein Mehrkanal-LED-System.

### HINTERGRUND

In der Beleuchtungstechnik gewinnen zunehmend Beleuchtungssysteme an Bedeutung, welche mehrere Kanäle aufweisen, womit sich anhand den Kanälen jeweils zugeordneten Leuchtmitteln verschiedene Raumbereiche ausleuchten und/oder aus verschiedenen Raumwinkeln ausleuchten und/oder die Lichtfarben einzelner Leuchtmittel - etwa je ein rotes, grünes und blaues Leuchtmittel zu weißem Licht - kombinieren lassen. Zunehmend sind solche Leuchtmittel LED-Module. Zum Betreiben der Leuchtmittel in einem Mehrkanal-Beleuchtungssystem kann insbesondere eine entsprechende Mehrkanal-Treibervorrichtung oder Mehrkanal-Betriebsvorrichtung verwendet werden.

Dazu wird diese je über einen Stromkreis mit dem jeweiligen Leuchtmittel elektrisch verbunden, wobei die Leuchtmittel jeweils einem der Kanäle zugordnet sind und geeignet elektrisch verbunden werden müssen. Dabei besteht jedoch das Risiko, dass die Leuchtmittel nicht ordnungsgemäß und damit geeignet mit den einzelnen Kanälen verbunden werden und aufgrund falscher Verbindung ein fehlerhafter Stromkreis ausgebildet wird. Dies kann dazu führen, dass sich die einzelnen Leuchtmittel nicht ordnungsgemäß steuern oder nicht betreiben lassen oder beim (fehlerhaften) Betrieb zerstört werden.

Üblicherweise muss daher die ordnungsgemäße elektrische Verbindung bei der Herstellung oder (Erst-) Montage oder Installation, etwa durch zusätzliche Herstellungsschritte unter Einsatz entsprechender Analysegeräte oder durch manuelle Kontrolle, sichergestellt werden. Auch sind Beleuchtungssysteme bekannt, welche ein verpolungssicheres Anschließen eines Leuchtmittels oder die Erkennung eines bestimmten Leuchtmittels ermöglichen, um einzelne Fehlerquellen auszuschließen. Die Druckschrift DE 10 2016 109487 A1 betrifft eine Kurzschlussdetektion in Lastketten, beispielsweise in Ketten von in Reihe geschalteten LEDs. Stromquellen liefern Strom an die LEDs und sind zwischen den LEDs und einer Versorgungsspannung angeschlossen. Eine globale Referenzspannung wird mit einer Anzahl von LEDs jeder Kette multipliziert, um eine jeweilige kettenindividuelle Vorwärtsreferenzspannung zu erhalten. Ein Fensterkomparator vergleicht eine gemessene Ausgangsspannung jeder Kette mit ihrer jeweiligen kettenindividuellen Vorwärtsreferenzspannung, um zu analysieren, ob alle LEDs dieser Kette funktionieren oder ob es einen Kurzschluss in einer oder mehreren der LEDs der Kette gibt.

### ZUSAMMENFASSUNG DER ERFINDUNG

Es besteht Bedarf, die Herstellung, Montage, Installation oder Wartung von Mehrkanal-Beleuchtungssystemen sowie von deren Komponenten zu verbessern und dabei insbesondere die elektrische Verbindung mit den Leuchtmitteln zu erleichtern und/oder das Risiko für oder die Folgen von einer fehlerhaften elektrischen Verbindung zu reduzieren.

Die Erfindung löst die Aufgabe jeweils durch eine Mehrkanal-LED-Treibervorrichtung, ein Verfahren zum Betreiben einer Mehrkanal-LED-Treibervorrichtung und eine Betriebsvorrichtung zum Betreiben mehrerer LED-Module gemäß den unabhängigen Ansprüche 1 und 10 Vorteilhafte Ausführungsformen, Weiterbildungen und Varianten der vorliegenden Erfindung sind insbesondere Gegenstand der Unteransprüche.

Ein erster Aspekt der Erfindung betrifft eine Mehrkanal-LED-Treibervorrichtung zur Stromversorgung mehrerer LED-Module. Die Mehrkanal-LED-Treibervorrichtung weist wenigstens zwei Versorgungskanäle je für ein LED-Modul sowie eine Ansteuerungseinrichtung auf. Dabei weisen die Versorgungskanäle jeweils einen Stromausgang und einen Messeingang auf. Die Ansteuerungseinrichtung ist eingerichtet, je Versorgungskanal jeweils wenigstens einen elektrischen Parameter am Stromausgang abhängig von einer jeweiligen Eingangsgröße, die mit einem elektrischen Parameter am Messeingang des jeweiligen Versorgungskanals korrespondiert, zu steuern. Zudem ist die Ansteuerungseinrichtung eingerichtet, wenigstens für einen der Versorgungskanäle zu bestimmen, ob bei Ansteuerung des Stromausgangs dieses Versorgungskanals bei der Eingangsgröße bezüglich dieses Versorgungskanals ein entsprechendes Antwortsignal ausbleibt, und/oder zu bestimmen, ob die Eingangsgröße bezüglich eines anderen Versorgungskanals einem Antwortsignal entspricht. Dabei ist die Ansteuerungseinrichtung eingerichtet, ein Fehlersignal bereitzustellen, falls wenigstens eines davon der Fall ist.

Im Sinne der Erfindung ist unter einem "LED-Modul" zumindest eine Vorrichtung - insbesondere als Komponente und Leuchtmittel eines Beleuchtungssystems - zu verstehen, welche eine oder mehrere LEDs - also Leuchtdioden - sowie wenigstens zwei Stromanschlüsse zum Ausbilden eines Stromkreises mit der Mehrkanal-LED-Treibervorrichtung und damit zur Stromversorgung der LEDs aufweist. Üblicherweise sind die Stromanschlüsse eines solchen LED-Moduls als mechanische Verbindungselemente ausgestaltet, sodass diese mechanisch - etwa mit einer Fassung für das LED-Modul - verbunden und so die elektrische Verbindung zur Mehrkanal-LED-Treibervorrichtung, insbesondere über zusätzliche elektrische Leiter wie Kabel, hergestellt wird. Dabei wird ein (Mehrkanal-) Beleuchtungssystem, welches LED-Module als Leuchtmittel aufweist und/oder zum Betreiben von diesen eingerichtet ist, insbesondere als (Mehrkanal-) LED-System bezeichnet. Alternativ oder zusätzlich kann ein LED-Modul im Sinne der Erfindung auch andere elektrisch betriebene Leuchtmittel als Leuchtdioden - insbesondere etwa Plasmalampen - aufweisen, wobei ein damit bestücktes System allgemein als (Mehrkanal-) Beleuchtungssystem oder auch, sofern sich die Merkmale entsprechen, insbesondere als (Mehrkanal-) LED-System bezeichnet.

Im Sinne der Erfindung ist unter "eingerichtet" zu verstehen, dass eine Vorrichtung nicht nur prinzipiell geeignet ist, eine bestimmte Funktion zu erfüllen - etwa erst nachdem ein bestimmter Programmcode aufgespielt worden ist, also die Vorrichtung programmiert worden ist, oder die Vorrichtung in bestimmter Weise geformt worden ist -, sondern die Vorrichtung bereits alle Mittel besitzt, um die Funktion tatsächlich zu erfüllen. Vorzugsweise ist dazu die Vorrichtung bereits mit einem Programmcode für diese Funktion programmiert und/oder bereits so geformt und/oder angeordnet und/oder weist dazu bereits eine solche Konfiguration auf, dass die Vorrichtung die Funktion tatsächlich erfüllt.

Ein Vorteil der Bereitstellung des Fehlersignals kann insbesondere darin liegen, dass eine fehlerhaft elektrische Verbindung zwischen einem der LED-Module, welches zumindest teilweise an diesen einen Versorgungskanal angeschlossen ist, und der Mehrkanal-LED-Treibervorrichtung über das Vorliegen des Fehlersignals erkannt werden kann. So lässt sich das Risiko für eine fehlerhafte elektrische Verbindung reduzieren und/oder bei der Herstellung, Montage, Installation oder Wartung eine solche fehlerhaft elektrische Verbindung - auch insbesondere ohne ein zusätzliches Analysegerät - feststellen und vorzugsweise durch Ausbilden einer neuen ordnungsgemäßen elektrischen Verbindung beheben.

Vorteilhaft lässt sich eine fehlerhafte elektrische Verbindung zwischen einem der LED-Module und einem der Versorgungskanäle zumindest für diesen einen Versorgungskanal dadurch bestimmen, dass bei Ansteuerung des Stromausgangs dieses Versorgungskanals bei der Eingangsgröße bezüglich dieses Versorgungskanal ein entsprechendes Antwortsignal, welches sich bei einem ordnungsgemäß verbundenen LED-Modul ergeben würde, ausbleibt. Dies kann typischerweise der Fall sein, wenn das LED-Modul zwar mit dem Stromausgangs dieses Versorgungssignals elektrisch verbunden worden ist, jedoch das LED-Modul nicht mit dem Messeingang dieses Versorgungskanals elektrisch verbunden worden ist. Hierbei könnte insbesondere einer der Stromanschlüsse des LED-Moduls zwar mit dem Stromausgang verbunden sein, aber der andere der Stromanschlüsse überhaupt nicht elektrisch verbunden sein oder mit einem Messeingang eines anderen Versorgungskanals verbunden sein.

Für diesen zweiten typischen Fehlerfall beim elektrischen Verbinden der LED-Module mit einer Mehrkanal-LED-Treibervorrichtung lässt sich das Vorliegen eines solchen Fehlers vorteilhaft insbesondere auch - also zusätzlich oder alternativ - dadurch bestimmen, dass die Eingangsgröße bezüglich eines anderen Versorgungskanals einem Antwortsignal entspricht, welches bei Ansteuerung des Stromausgangs dieses wenigstens einen Versorgungskanals, für welchen das Bestimmen ausgeführt wird, bei der Eingangsgröße bezüglich dieses Versorgungskanals zu erwarten gewesen wäre. Dabei lassen sich vorteilhaft in einigen Varianten auf Basis der jeweiligen Antwortsignale bei den Eingangsgrößen für mehr als einen der Versorgungskanäle derartige fehlerhaft elektrische Verbindungen bestimmen, wodurch für mehr als einen Versorgungskanal bei Vorliegen einer fehlerhaften Verbindung ein Fehlersignal bereitgestellt werden kann, wobei vorzugsweise das Fehlersignal die jeweils fehlerhaft verbundenen Versorgungskanäle kennzeichnet, oder wobei entsprechend mehrere Fehlersignale - etwa je ein Fehlersignal für je einen Versorgungskanal - bereitgestellt werden.

Die Ansteuerungseinrichtung kann gemäß einigen Ausführungsformen eingerichtet sein, diesen wenigstens einen Versorgungskanal und den anderen Versorgungskanal bzw. die anderen Versorgungskanäle zeitlich versetzt anzusteuern. Auf diese vorteilhafte Weise lassen sich, insbesondere sofern die Antwortsignale bei den jeweiligen Messeingängen ansonsten gleich wären, diese Antwortsignale unterscheiden, sodass bestimmt werden kann, bei Ansteuerung welches der Stromausgänge das Antwortsignal am jeweiligen Messeingang vorliegt. So lassen sich die einzelnen elektrischen Verbindungen und Stromkreise zwischen den Stromausgängen und bei den jeweiligen Messeingängen bestimmen und damit insbesondere ein Fehlersignal bereitstellen, welches die jeweils fehlerhaft verbundenen Versorgungskanäle bzw. LED-Module kennzeichnet, wodurch sich insbesondere die Fehlersuche erleichtern lässt und/oder insbesondere bei der Herstellung sich eine derartige fehlerhaft Verbindung in einem Korrekturschritt im Herstellungsverfahren beheben lässt.

Bei einigen Ausführungsformen wird das Fehlersignal bei Ausbleiben des entsprechenden Antwortsignals oder bei entsprechender Eingangsgröße bezüglich eines anderen Versorgungskanals erst nach einer vorbestimmten Zeitspanne bereitgestellt. Auf diese vorteilhafte Weise lässt sich ein Bereitstellen des Fehlersignals etwa dann verhindern, wenn aufgrund kurzfristiger Störungen ein entsprechendes Antwortsignal ausbleibt bzw. bei einem anderen Versorgungskanal vorliegt.

In einigen Ausführungsformen ist die Ansteuerungseinrichtung eingerichtet, das Ausbleiben des entsprechenden Antwortsignals bei der Eingangsgröße bezüglich dieses wenigstens einen Versorgungskanals zu bestimmen, indem diese bestimmt, ob diese Eingangsgröße nicht zwischen einem unteren und einem oberen Grenzwert liegt. Ein Vorteil des Bestimmens des Ausbleibens des entsprechenden Antwortsignals mittels dem unteren und dem oberen Grenzwert kann insbesondere darin liegen, dass eine solche Überprüfung von Grenzwerten mit einem geringen Schaltungsaufwand und/oder einer geringen Rechenleistung realisiert werden kann und/oder eine derartige Überprüfung eines Überschreiten oder Unterschreiten eines Grenzwerts verlässlich durchgeführt werden kann. Auch kann ein Vorteil darin liegen, dass hierfür nur zwei Parameter, nämlich der obere und der untere Grenzwert, festgelegt - etwa durch den Hersteller - werden müssen und diese sich auch insbesondere leicht bestimmen lassen. So kann vorteilhaft in einigen Varianten der untere Grenzwert eine vorbestimmte minimale Spannung sein, welche am Messeingang aufgrund eines für diesen entsprechenden Stromausgang minimalen Stroms bei Stromfluss durch das LED-Modul auftritt, und/oder der obere Grenzwert einen vorbestimmten Abstand von einer maximalen Spannung haben, welche dann auftritt, wenn an diesem Stromausgang dieses Versorgungskanals der maximal mögliche Strom ausgegeben wird.

Gemäß einigen Ausführungsformen, bei welchen das Ausbleiben des entsprechenden Antwortsignals bei der Eingangsgröße bezüglich dieses wenigstens einen Versorgungskanals auf Basis von Grenzwerten erfolgt, darf dabei diese Eingangsgröße über eine vorbestimmte Zeitspanne nicht zwischen dem unteren und dem oberen Grenzwert liegen. Auf diese vorteilhafte Weise lässt sich ein Bestimmen des Ausbleibens des entsprechenden Antwortsignals und damit ein Bereitstellen des Fehlersignals in solchen Fällen verhindern, in denen die Eingangsgröße - etwa aufgrund einer kurzfristigen Störung wie einer elektromagnetischen Einstreuung oder bei Inbetriebnahme der Mehrkanal-LED-Treibervorrichtung - verhindern.

In einigen Ausführungsformen ist die Ansteuerungseinrichtung eingerichtet, das Entsprechen des Antwortsignals bei der Eingangsgröße bezüglich eines anderen Versorgungskanals zu bestimmen, indem diese bestimmt, ob der Absolutbetrag der Eingangsgröße bezüglich des anderen Versorgungskanals oberhalb eines oberen Grenzwertes liegt. Ein Vorteil der Bestimmung auf Basis dieses oberen Grenzwertes kann insbesondere darin liegen, dass eine solche Bestimmung mit einfachen Mitteln und damit auch verlässlich realisiert werden kann.

Gemäß einigen Ausführungsformen, bei welchen das Entsprechen des Antwortsignals bei der Eingangsgröße bezüglich eines anderen Versorgungskanals auf Basis eines oberen Grenzwerts erfolgt, muss für das Bestimmen des Entsprechens des Antwortsignals der Absolutbetrag der Eingangsgröße bezüglich des anderen Versorgungskanals über eine vorbestimmte Zeitspanne oberhalb des oberen Grenzwerts liegen. Insbesondere lässt sich vorteilhaft eine fehlerhafte Ausgabe des Fehlersignals - etwa aufgrund kurzzeitiger Störungen - vermeiden.

In einigen Ausführungsformen ist die Ansteuerungseinrichtung eingerichtet, bei Vorliegen des Fehlersignals zumindest den elektrischen Parameter am Stromausgang des Versorgungskanals, auf welchen sich das Fehlersignal bezieht, oder jeweils den elektrischen Parameter auf den Stromausgängen von allen Versorgungskanälen auf einen vorbestimmten Wert zu stellen. Auf diese vorteilhafte Weise lässt sich der fehlerhaft verbundene Versorgungskanal bzw. lassen sich im Fehlerfall alle Versorgungskanäle in einem Fehlermodus betreiben und es können insbesondere solche elektrische Parameter gewählt werden, bei welchen das Risiko für eine Beschädigung der LED-Module und/oder der Mehrkanal-LED-Treibervorrichtung reduziert werden kann.

Gemäß einigen Ausführungsformen, bei welchen bei Vorliegen des Fehlersignals ein elektrischer Parameter am Stromausgang auf einen vorbestimmten Wert gestellt wird, ist der vorbestimmte Wert oder sind die vorbestimmten Werte für mehrere Stromausgänge des Versorgungskanals bzw. der Versorgungskanäle - insbesondere von allen Versorgungskanälen - so bestimmt, dass kein elektrischer Strom oder keine elektrische Leistung an dem Stromausgang bzw. an den Stromausgängen ausgegeben wird. So lässt sich eine Beschädigung oder Zerstörung bei einem Fehler vermeiden.

Bei einigen Ausführungsformen kann die Ansteuerungseinrichtung eingerichtet sein, für wenigstens zwei Versorgungskanäle, also wenigstens für einen ersten und einen zweiten der Versorgungskanäle auf Basis der Antwortsignale zu bestimmen, ob die Ansteuerung des Stromausgangs des ersten Versorgungskanals das Antwortsignal bei der Eingangsgröße bezüglich des Messeingangs des zweiten Versorgungskanals bedingt und umgekehrt. Dabei kann die Ansteuerungseinrichtung zudem eingerichtet sein, in diesem Falle eine Zuordnung zwischen dem Stromausgang und dem Messeingang des ersten Versorgungskanals sowie zwischen dem Stromausgang und dem Messeingangs des zweiten Versorgungskanals, insbesondere automatisch, so neu zu konfigurieren, dass dem ersten Versorgungskanal der bisherigen Messeingang des zweiten Versorgungskanals sowie dem zweiten Versorgungskanals der bisherige Messeingang des ersten Versorgungskanals zugeordnet wird. Auf diese vorteilhafte Weise lässt sich bzw. lassen sich fehlerhafte elektrische Verbindungen bei den LED-Modulen am ersten und am zweiten Versorgungskanal durch eine Neukonfiguration automatisch beheben, wodurch insbesondere kein Lösen und Neuherstellen bzw. Ausbilden der elektrischen Verbindung erforderlich ist und/oder die Herstellung vereinfacht und die Betriebssicherheit - etwa aufgrund der Vermeidung der Zerstörung der LED-Module oder der Mehrkanal-LED-Treibervorrichtung - gesteigert werden kann.

Auch kann in einigen Ausführungsformen die Ansteuerungseinrichtung eingerichtet sein, eine Konfiguration von einem Benutzer - etwa einem Installateur - zu empfangen und auf Basis dieser Konfiguration die Stromausgänge und Messeingänge neu zuzuordnen. So lässt sich eine etwaige fehlerhafte elektrische Verbindung in einem Herstellungsschritt oder bei der Montage oder der Installation - etwa eines neuen, zusätzlichen oder zu ersetzenden LED-Moduls -, insbesondere gezielt und/oder manuell, korrigieren oder lassen sich zumindest deren Folgen reduzieren.

Gemäß einigen Ausführungsformen, bei welchen die Zuordnung zwischen Stromausgängen und Messeingängen - insbesondere automatisch - neu bzw. re-konfigurierbar ist, kann die Ansteuerungseinrichtung eingerichtet sein, die Konfiguration der Zuordnung zumindest bezüglich der Stromausgänge und der Messeingänge des ersten und des zweiten Versorgungskanals als Konfigurationsdaten zu speichern und die Stromausgänge und die Messeingänge entsprechend der Konfigurationsdaten zuzuordnen.

Gemäß einigen Ausführungsformen, bei welchen die Zuordnung von Messeingängen und Stromausgängen insbesondere neu bzw. re-konfigurierbar ist, kann die Mehrkanal-LED-Treibervorrichtung eine persistente Speichereinrichtung zum Speichern von Konfigurationsdaten sowie eine Datenschnittstelle aufweisen. Zudem kann die Mehrkanal-LED-Treibervorrichtung eingerichtet sein, Konfigurationsdaten mittels der Datenschnittstelle zu empfangen und in der persistenten Speichereinrichtung zu speichern. Ein Vorteil des Empfangen der Konfigurationsdaten über die Datenschnittstelle kann insbesondere darin liegen, dass diese gezielt zur Beseitigung/Umgehung von fehlerhaften elektrischen Verbindungen, insbesondere von einer externen Quelle - etwa durch einen Benutzer - oder von einem Teil der LED-Treibervorrichtung, welche die tatsächliche elektrische Konfiguration bestimmt, eingespeichert werden können.

Gemäß einigen Ausführungsformen der Mehrkanal-LED-Treibervorrichtung, welche zum Speichern von Konfigurationsdaten eingerichtet sind, kann die Ansteuerungseinrichtung eingerichtet sein, die Stromausgänge und die Messeingänge der Versorgungskanäle entsprechend der Konfigurationsdaten zuzuordnen. Auf diese vorteilhafte Weise lassen sich die Folgen von fehlerhaften elektrischen Verbindungen nicht nur - etwa durch Stromlos-Stellen der jeweiligen Versorgungskanäle - reduzieren, etwa um eine mögliche Zerstörung des LED-Moduls zu vermeiden, sondern auch die fehlerhaften Verbindungen so beheben, d.h. insbesondere umgehen, dass dennoch ein - zumindest im Wesentlichen - regulärer Betrieb der LED-Module ermöglicht wird.

Gemäß einigen Ausführungsformen kann die Mehrkanal-LED-Treibervorrichtung eine persistente Speichereinrichtung zum Speichern von Konfigurationsdaten aufweisen.

Ein Vorteil einer persistenten Speichereinrichtung kann insbesondere darin liegen, dass Konfigurationsdaten persistent - also insbesondere dauerhaft - gespeichert werden können, wodurch insbesondere Konfigurationsdaten auch bei einer erneuten Inbetriebnahme der Mehrkanal-LED-Treibervorrichtung - etwa bei ihrer (Neu-) Montage oder einer (Neu-) Installation von LED-Modulen oder nachdem diese über eine bestimmte Zeit stromlos gewesen ist - bereits vorliegen und nicht erneut aufgespielt, eingegeben oder bestimmt werden müssen.

Auch kann in einigen Ausführungsformen die Ansteuerungseinrichtung eingerichtet sein, Konfigurationsdaten bezüglich der Zuordnung von Messeingängen und Stromausgängen bei jedem (Neu-) Start der Ansteuerungseinrichtung bzw. der Mehrkanal-LED-Treibervorrichtung erneut zu bestimmen. Auf diese vorteilhafte Weise lässt sich vermeiden, dass eine fehlerhafte Konfiguration bzw. fehlerhafte Konfigurationsdaten verwendet werden, nachdem die tatsächliche elektrischen Konfiguration, d.h. die elektrischen Verbindungen zwischen der LED-Treibervorrichtung und den LED-Modulen, zwischen einer vorhergehenden Inbetriebnahme und einer darauffolgenden späteren Inbetriebnahme bzw. einem Neustart sich geändert haben. In einigen Varianten kann ein Vorteil auch darin liegen, dass keine persistente Speichereinrichtung für die Konfigurationsdaten erforderlich ist, sondern ein volatiler Speicher verwendet werden kann, wodurch insbesondere die Herstellung vereinfacht werden kann.

Gemäß einigen Ausführungsformen kann die Mehrkanal-LED-Treibervorrichtung des Weiteren eine Analog-Digital-Wandler-Einrichtung für die Messeingänge und wenigstens eine Steuerungskomponente für die Stromausgänge, insbesondere je eine Steuerungskomponente für je einen Stromausgang, aufweisen. Zudem kann die Ansteuerungseinrichtung einen Mikrocontroller aufweisen oder zumindest im Wesentlichen aus einem solchen sowie vorzugsweise einer Speichereinrichtung bestehen. Dabei kann in einer solchen Ausführungsform der Mikrocontroller mit der Analog-Digital-Wandler-Einrichtung sowie der wenigstens einen Steuerungskomponente datenverbunden sein. Zudem kann der Mikrocontroller mittels computerlesbarer Anweisungen, welche insbesondere auf der Speichereinrichtung oder einer zusätzlichen nur lesbaren Speichereinrichtung gespeichert sein können, eingerichtet sein, entsprechend der Ansteuerungseinrichtung der vorhergehenden Aspekte und Ausführungsformen sowie Weiterbildungen und Varianten auf Basis der Eingangsgrößen bezüglich der Messeingänge und etwaiger Konfigurationsdaten die wenigstens eine Steuerungskomponente der Mehrkanal-LED-Treibervorrichtung anzusteuern und das Fehlersignal bereitzustellen. Auf diese vorteilhafte Weise lässt sich die Ansteuereinrichtung mittels eines Mikrocontrollers realisieren, sodass bei der Herstellung übliche Komponenten eingesetzt werden können, wodurch insbesondere die Herstellung vereinfacht und mögliche Fehlerquellen - etwa aufgrund der Verwendung von Spezialkomponenten, welche nur in geringer Stückzahl oder Sonderfertigung hergestellt werden - reduziert werden können. Auch kann in einigen vorteilhaften Varianten mit reprogrammierbaren Mikroprozessor, d.h. insbesondere einem Mikroprozessor, dessen computerlesbaren Anweisungen auf einem wiederbeschreibbaren Speicher gespeichert sind, lassen sich die Ansteuerung der wenigstens einen Steuerungskomponente und/oder das Bereitstellen des Fehlersignals über eine Reprogrammierung anpassen. Auch wird durch den Mikrocontroller insbesondere ermöglicht, die Ansteuerung und das Fehlersignal auf Basis von Konfigurationsdaten anzupassen.

In einigen Ausführungsformen kann der jeweils wenigstens eine elektrische Parameter am Stromausgang einer Stromstärke sein.

In einigen Ausführungsformen kann der elektrische Parameter am Messeingang des jeweiligen Versorgungskanals eine elektrische Spannung sein.

Ein Vorteil des elektrischen Parameters der Stromstärke kann insbesondere darin liegen, dass die Leistung und/oder Betriebsweise von üblichen LEDs mittels der Stromstärke, welche durch diese fließt, gesteuert wird. Dabei kann der zulässige Betriebsbereich eine LED bezüglich des Stroms größer als bezüglich der Spannung sein, sodass durch die Stromsteuerung insbesondere das Steuern erleichtert wird und/oder stabiler erfolgen kann. Auch kann dabei insbesondere die Stromstärke, welche durch die jeweiligen LEDs fließt, mittels eines Shunt-Widerstands am Messeingang als elektrische Spannung erfasst werden. Auf diese vorteilhafte Weise lässt sich die Betriebsweise der LED bzw. des jeweiligen LED-Moduls über die Stromstärke, welche durch dieses fließt, steuern und vorzugsweise - sofern ein ordnungsgemäßer Regelungskreis vorliegt - auch regeln. Dabei kann in einigen vorteilhaften Varianten, sofern kein ordnungsgemäßer Regelungskreis vorliegt - etwa aufgrund fehlerhafter elektrischer Verbindungen - , dies erkannt und ein entsprechendes Fehlersignal bereitgestellt werden oder ein ordnungsgemäßer Regelungskreis durch eine Neukonfiguration - insbesondere automatisch - erzielt werden.

In einigen Ausführungsformen kann die Mehrkanal-LED-Treibervorrichtung eine Auslöseschnittstelle aufweisen und eingerichtet sein, beim Empfang eines Auslösesignals mittels dieser Schnittstelle das Bestimmen, ob das entsprechende Antwortsignal ausbleibt und/oder ob die Eingangsgröße bezüglich eines anderen Versorgungskanals dem Antwortsignal entspricht, auszuführen. Um insbesondere einem Hersteller, Monteur oder Installateur ein solchen Auslösen dieses Bestimmens zu ermöglichen, kann in einigen vorteilhaften Varianten die Auslöseschnittstelle als Benutzerschnittstelle ausgebildet sein oder eine solche aufweisen. Alternativ oder zusätzlich kann in einigen vorteilhaften Varianten die Auslöseschnittstelle als Datenschnittstelle ausgebildet sein oder eine solche aufweisen, wodurch dieses Bestimmen mittels einer zusätzlichen - insbesondere automatisierten - Vorrichtung, welche datenverbunden mit der Auslöseschnittstelle ist, ausgelöst werden kann, wodurch insbesondere das Auslösen und damit Überprüfen automatisch ausgelöst werden kann und sich so etwa die Effizienz bei der Herstellung steigern lässt.

In einigen Ausführungsformen kann die Mehrkanal-LED-Treibervorrichtung eigerichtet sein, das Bestimmen, ob das entsprechende Antwortsignal ausbleibt und/oder ob die Eingangsgröße bezüglich eines anderen Versorgungskanals dem Antwortsignal entspricht, automatisch auszuführen. In einigen Varianten kann dies (jeweils bzw. mehrfach und wiederholt) nach einem vorbestimmten Zeitintervall erfolgen. In einigen Varianten kann sich durch ein bestimmtes Auslöseereignis - insbesondere bei einem (Neu-) Start oder einer Inbetriebnahme der Mehrkanal-LED-Treibervorrichtung und/oder bei oder nach der Herstellung eines Mehrkanal-LED-Systems mit einer solchen Mehrkanal-LED-Treibervorrichtung und/oder bei/nach ihrer Montage und/oder bei/nach Installation eines LED-Moduls - ausgelöst werden.

Auch kann in einigen vorteilhaften Ausführungsformen die Mehrkanal-LED-Treibervorrichtung eingerichtet sein, das Bestimmen auf Basis einer Kombination von (externen) Auslösesignal und automatischen Ausführen auszuführen. In einigen Varianten kann dabei das Bestimmen bereits ausgeführt werden, wenn eines davon vorliegt, also insbesondere bei Vorliegen eines Auslösesignals oder nach einem vorbestimmten Zeitintervall oder bei Vorliegen eines Auslöseereignisses. Alternativ kann in einigen vorteilhaften Varianten das Bestimmen auch nur dann ausgeführt werden, wenn sowohl ein Auslösesignal als auch ein Auslöseereignis vorliegt oder ein vorbestimmtes Zeitintervall abgelaufen ist, wodurch insbesondere ein Diagnose-Betriebsmodus ermöglicht wird, welcher durch ein Auslösesignal aktivierbar ist, sodass sich insbesondere eine unkontrollierte automatische Ausführung des Bestimmens - welche etwa bei einem (End-) Benutzer, insbesondere einem Durchschnittsverbraucher, zu weiteren Fehlern führen könnte - vermeiden.

Ein zweiter Aspekt der Erfindung betrifft ein Verfahren zum Betreiben einer Mehrkanal-LED-Treibervorrichtung, welche mehrere Versorgungskanäle mit je einem Stromausgang und einem Messeingang aufweist. Das Verfahren weist Folgendes auf. Bei dem Verfahren wird je Versorgungskanal eine Eingangsgröße, welche mit einem elektrischen Parameter am Messeingang des jeweiligen Versorgungskanals korrespondiert, erfasst. Zudem wird ein Steuerungsmittel so angesteuert, dass ein elektrischer Parameter am Stromausgang des jeweiligen Versorgungskanals abhängig von der jeweiligen Eingangsgröße gesteuert wird. Für wenigstens einen der Versorgungskanäle wird bestimmt, ob bei Ansteuerung des Stromausgangs dieses Versorgungskanals bei der Eingangsgröße bezüglich dieses Versorgungskanals ein entsprechendes Antwortsignal ausbleibt oder ob die Eingangsgröße bezüglich eines anderen Versorgungssignals einem Antwortsignal entspricht. Falls wenigstens eines davon der Fall ist, wird ein Fehlersignal bereitgestellt.

Die bereits vorausgehend genannten möglichen Vorteile sowie Ausführungsformen, Weiterbildungen oder Varianten des ersten Aspekts der Erfindung gelten entsprechend auch für das erfindungsgemäße Verfahren.

In einigen Ausführungsformen kann das Verfahren entsprechend und mittels einer der Mehrkanal-LED-Treibervorrichtungen gemäß einem/einer der vorausgehend genannten Aspekte, Ausführungsformen, Weiterbildungen oder Varianten durchgeführt werden.

Ein dritter Aspekt der Erfindung betrifft ein Computerprogrammprodukt zum Betreiben einer Mehrkanal-LED-Treibervorrichtung, welche einen Mikrocontroller aufweist. Dabei weist das Computerprogrammprodukt computerlesbare Anweisungen auf oder stellt diese bereit, wobei diese computerlesbaren Anweisungen bei Ausführung auf dem Mikrocontroller diesen veranlassen, ein Verfahren gemäß des zweiten Aspekts der Erfindung oder seiner Ausführungsformen, Weiterbildungen oder Varianten, insbesondere mittels einer Mehrkanal-LED-Treibervorrichtung gemäß dem ersten Aspekt der Erfindung oder seiner Ausführungsformen, Weiterbildungen oder Varianten auszuführen.

Im Sinne der Erfindung ist unter einem "Computerprogrammprodukt" zumindest ein Programmcode mit computerlesbaren Anweisungen oder ein Erzeugnis, das solche computerlesbaren Anweisungen aufweist oder bereitstellt, zu verstehen. Insbesondere können die computerlesbaren Anweisungen zunächst in einer mittelbaren Form vorliegen, welche zunächst in computerlesbare Anweisungen umgewandelt werden müssen - etwa als ein komprimiertes Computerprogramm. Auch kann das Computerprogrammprodukt als Erzeugnis weitere Bestandteile wie etwa einen Dongle - insbesondere zur Erschwerung einer Weitergabe des Computerprogramms oder zur Erschwerung des Herstellens von zusätzlichen Kopien davon - aufweisen, mit entsprechenden Verpackungen oder Handbüchern kombiniert sein oder - etwa auf einem Server - als Download angeboten und vorzugsweise mit einer entsprechenden Beschreibung auf einer Internetseite versehen sein.

Die bereits vorausgenannten möglichen Vorteile, Ausführungsformen oder Varianten der vorhergehenden Aspekte der Erfindung gelten entsprechend auch für das erfindungsgemäße Computerprogrammprodukt.

In einigen Ausführungsformen kann das Computerprogrammprodukt einen nichtflüchtigen Speicher, insbesondere einen Flash-Speicher oder einen nichtflüchtigen Datenträger wie eine CD-ROM, eine Festplatte oder einen USB-Speicherstick aufweisen, auf dem die computerlesbaren Daten gespeichert sind. Auf diese vorteilhafte Weise lassen sich die computerlesbaren Anweisungen physisch mittels dieses Datenspeichers transportieren oder übertragen.

In einigen Ausführungsformen weist das Computerprogramm eine Datenverarbeitungsvorrichtung auf, welche eingerichtet ist, die computerlesbaren Daten bereitzustellen. Insbesondere kann eine solche Datenverarbeitungseinrichtung ein Server oder ein Dongle sein. Zum Bereitstellen der computerlesbaren Daten kann die Datenverarbeitungsvorrichtung eingerichtet, mittels einer Datenverbindung die computerlesbaren Anweisungen an eine Mehrkanal-LED-Treibervorrichtung, insbesondere eine Ansteuerungseinrichtung von dieser oder einen Mikrocontroller von dieser zu übertragen, auf welchem die computerlesbaren Anweisungen auszuführen sind. Auch können die computerlesbaren Anweisungen in einer Speichereinrichtung der LED-Treibervorrichtung oder der Ansteuerungseinrichtung oder des Mikrocontrollers gespeichert werden. Auf diese vorteilhafte Weise lassen sich die computerlesbaren Anweisungen unabhängig von einem physischen Transport für den Mikrocontroller zur dortigen Ausführung bereitstellen.

Ein vierter Aspekt der Erfindung betrifft eine Betriebsvorrichtung zum Bereitstellen mehrerer LED-Module. Diese weist mehrere Versorgungssignale mit je einem Versorgungs- und einem Regelungsanschluss jeweils für eines der LED-Module und je Regelungsanschluss einen Shunt-Widerstand auf. Zudem weist diese eine Mehrkanal-LED-Treibervorrichtung gemäß dem ersten Aspekt der Erfindung oder einer seiner Ausführungsformen, Weiterbildungen oder Varianten auf. Dabei ist jeweils einer der Versorgungsanschlüsse mit einem entsprechenden Stromausgang der Mehrkanal-LED-Treibervorrichtung elektrisch verbunden. Zudem ist der elektrische Parameter am Messeingang des jeweiligen Versorgungskanals eine elektrische Spannung. Außerdem ist jeweils der Shunt-Widerstand mit dem entsprechenden Regelungsanschluss sowie am gleichen Knotenpunkt mit dem entsprechenden Messeingang der Mehrkanal-LED-Treibervorrichtung elektrisch so verbunden, dass die an diesem Knotenpunkt anliegende Spannung von dem Strom, welcher in den Regelungsanschluss fließt, abhängig ist. Dabei kann in einigen vorteilhaften Varianten die anliegende elektrische Spannung linear von dem Regelungsanschluss abhängig sein, wodurch insbesondere eine einfache Steuerung ermöglicht wird.

Die bereits vorausgehend genannten Vorteile sowie Ausführungsbeispiele, Weiterbildungen oder Varianten der vorhergehenden Aspekte der Erfindung gelten entsprechend auch für die erfindungsgemäße Betriebsvorrichtung.

Ein fünfter Aspekt der Erfindung betrifft ein Mehrkanal-LED-System, welches wenigstens zwei LED-Module sowie eine Betriebsvorrichtung gemäß dem vierten Aspekt der Erfindung aufweist. Dabei sind die LED-Module mit der Betriebsvorrichtung, insbesondere entweder integral oder lösbar, verbunden, um eine elektrische Verbindung auszubilden. Zudem weisen die LED-Module jeweils zwei Stromanschlüsse auf, wovon ein erster mit je einem der Versorgungsanschlüsse der Betriebsvorrichtung und ein zweiter je mit einem der Regelungsanschlüsse der Betriebsvorrichtung elektrisch verbunden ist.

Die bereits vorausgehend genannten möglichen Vorteile sowie Ausführungsformen, Weiterbildungen und Varianten der vorhergehenden Aspekte der Erfindung gelten entsprechend auch für das erfindungsgemäße Mehrkanal-LED-System.

In einigen vorteilhaften Ausführungsformen kann eine, können vorzugsweise alle elektrischen Verbindungen zwischen den LED-Modulen und der Betriebsvorrichtung lösbar ausgebildet sein. Hierzu kann eine solche Ausführungsform eine oder mehrere Fassungen für LED-Module aufweisen, welche zur Aufnahme von LED-Modulen so eingerichtet sind und insbesondere über Kabel, Drähte oder Leiterbahnen auch mit der Betriebsvorrichtung elektrisch verbunden sind, dass die Fassungen jeweils die elektrischen Verbindungen zwischen LED-Modulen und Betriebsvorrichtung ausbilden, wenn die Fassungen die LED-Module aufnehmen. So lassen sich vorteilhaft die LED-Module austauschen.

In einigen alternativen und vorteilhaften Ausführungsformen ist eine, sind vorzugsweise alle elektrischen Verbindungen zwischen den LED-Modulen und der Betriebsvorrichtung integral ausgebildet. Hierbei können in einigen Varianten die LED-Module fest mit der Betriebsvorrichtung, etwa auf einer Leiterplatte oder über angelötete Kabel oder Drähte, verlötet sein. Hierdurch lässt sich eine kostengünstige Herstellung, insbesondere durch Verzicht auf etwaige Fassungen für LED-Module, und/oder ein besonders robuster Betrieb ermöglichen, da insbesondere das Risiko reduziert wird, dass sich elektrische Verbindungen lösen, wie etwa durch einen Wackelkontakt bei einer Fassung oder durch Lösen eines LED-Moduls aus einer Fassung, etwa aufgrund von mechanischen Belastungen.

Während das Bereitstellen des Fehlersignals und gegebenenfalls die (Neu-) Konfiguration der Zuordnung zwischen Messeingängen und Stromausgängen bezüglich wenigstens eines sowie eines anderen Versorgungskanals beziehungsweise eines ersten und eines zweiten Versorgungskanals beschrieben worden ist, können in einigen vorteilhaften Ausführungsformen solche Fehlersignale, ein Einstellen von bestimmten elektrischen Parametern am Stromausgang oder an den Stromausgängen und/oder eine (Neu-) Konfiguration auch für mehrere Kanäle - insbesondere für alle Versorgungskanäle - eingerichtet sein. Auf diese vorteilhafte Weise lässt sich die elektrische Verbindung mit den LED-Modulen erleichtern und/oder das Risiko oder die Folgen von einer fehlerhaften elektrischen Verbindung reduzieren. Umgekehrt kann in einigen Ausführungsformen der Herstellungsaufwand und/oder der Installationsaufwand dadurch reduziert werden, dass für einige der Versorgungskanäle und damit entsprechende LED-Module - die insbesondere bei der Herstellung bereits integral verbunden sein können - eine derartige Neukonfiguration oder das Bereitstellen eines Fehlersignals nicht vorgesehen ist, wodurch sich insbesondere der Herstellungs- und/oder Materialaufwand reduzieren lässt.

Verfahren, Vorrichtungen und Systeme nach Ausführungsformen sowie nachfolgenden Ausführungsbeispielen ermöglichen insbesondere eine Verbesserung bei der Herstellung, Montage, Installation oder Wartung von Mehrkanal-Beleuchtungssystemen, insbesondere Mehrkanal-LED-Systemen. Dabei können insbesondere einige Ausführungsformen und/oder Ausführungsbeispiele des Verfahrens zumindest teilweise automatisiert/automatisch ausgeführt werden. Dazu kann insbesondere in einigen Ausführungsformen oder Ausführungsbeispielen eine Vorrichtung oder ein System oder ein Teil davon eingerichtet sein, Verfahrensteile automatisch auszuführen, bzw. können Verfahrensteile mittels dieser Vorrichtungen, Systeme und/oder Teile davon automatisch ausgeführt werden.

Im Sinne der Erfindung ist unter "automatisch" zumindest zu verstehen, dass ein Teil eines Verfahrens, insbesondere ein Verfahrensschritt, und/oder eine Funktionalität einer Vorrichtung, ohne einen menschlichen Eingriff ausgeführt werden kann.

Verschiedene Wirkungen und Vorteile lassen sich mit Systemen, Vorrichtungen und Verfahren nach Ausführungsformen sowie nachfolgenden Ausführungsbeispielen erzielen. Insbesondere lassen sich die Herstellung, Montage, Installation oder Wartung von Mehrkanal-LED-Systemen sowie von deren Komponenten verbessern und dabei insbesondere das elektrische Verbinden von LED-Modulen mit Betriebsvorrichtungen für diese, insbesondere mit Mehrkanal-LED-Treibervorrichtungen, erleichtern und/oder das Risiko für oder die Folgen von einer fehlerhaften elektrischen Verbindung reduzieren. Hierdurch kann insbesondere der Fertigungsaufwand und/oder die Fertigungskosten reduziert werden, der Personalaufwand bei einer Montage oder Installation verringert und/oder die Betriebssicherheit - insbesondere die Ausfallsicherheit - gesteigert werden.

Weitere Vorteile, Merkmale und Anwendungsmöglichkeiten ergeben sich aus der nachfolgenden detaillierten Beschreibung von Ausführungsbeispielen und/oder aus den Figuren.

### KURZE BESCHREIBUNG DER FIGUREN

Die Erfindung wird nachfolgend unter Bezugnahme auf die Figuren anhand vorteilhafter Ausführungsbeispiele näher erläutert. Gleiche Elemente oder Bauteile der Ausführungsbeispiele werden im Wesentlichen durch gleiche Bezugszeichen gekennzeichnet, falls dies nicht anders beschrieben wird oder sich nicht anders aus dem Kontext ergibt.

Hierzu zeigen, teilweise schematisiert:
Fig. 1 ein Mehrkanal-LED-System mit ordnungsgemäß verbundenen LED-Modulen nach einer Ausführungsform;
Fig. 2 ein Mehrkanal-LED-System mit fehlerhaft verbundenen LED-Modulen nach einer Ausführungsform;
Fig. 3 eine Mehrkanal-LED-Treibervorrichtung zur Stromversorgung mehrerer LED-Module nach einer Ausführungsform;
Fig. 4 eine Betriebsvorrichtung zum Betreiben mehrerer LED-Module nach einer Ausführungsform; und
Fig. 5 ein Verfahren zum Betreiben einer Mehrkanal-LED-Treibervorrichtung nach einer Ausführungsform.

Die Figuren sind schematische Darstellungen verschiedener Ausführungsformen und/oder Ausführungsbeispiele der vorliegenden Erfindung. In den Figuren dargestellte Elemente und/oder Bauteile sind nicht notwendigerweise maßstabsgetreu dargestellt. Vielmehr sind die verschiedenen in den Figuren dargestellten Elemente und/oder Bauteile derart wiedergegeben, dass ihre Funktion und/oder ihr Zweck dem Fachmann verständlich werden.

In den Figuren dargestellte Verbindungen und Kopplungen zwischen funktionellen Einheiten und Elementen können auch als indirekte Verbindungen oder Kopplungen implementiert werden. Insbesondere können Datenverbindungen drahtgebunden oder drahtlos, also insbesondere als Funkverbindung, ausgebildet sein. Auch können bestimmte Verbindungen, etwa elektrische Verbindungen, etwa zur Energieversorgung, der Übersichtlichkeit halber nicht dargestellt sein.

### DETAILLIERTE BESCHREIBUNG VON AUSFÜHRUNGSBEISPIELEN

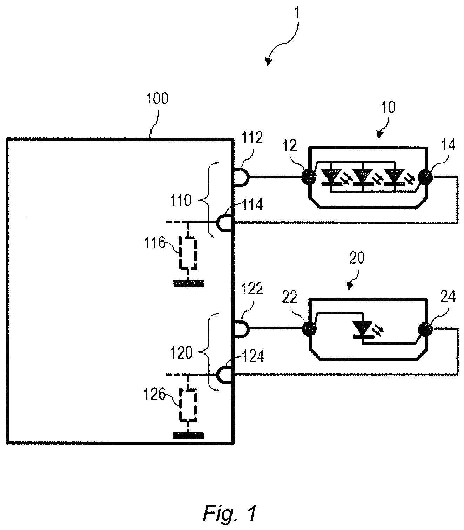

In Fig. 1 ist ein Mehrkanal-LED-System 1 nach einer Ausführungsform der vorliegenden Erfindung schematisch dargestellt.

In einem Ausführungsbeispiel weist das Mehrkanal-LED-System 1 zwei LED-Module 10, 20 sowie eine Betriebsvorrichtung 100 zum Betreiben dieser LED-Module auf. Dabei versteht es sich, dass das Mehrkanal-LED-System 1 auch weitere LED-Module und entsprechend eine Betriebsvorrichtung mit wenigstens einer entsprechenden Anzahl von zusätzlichen Kanälen zum Betreiben dieser LED-Module aufweisen kann.

Die LED-Module, also das erste LED-Modul 10 und das zweite LED-Modul 20, weisen jeweils wenigstens eine Leuchtdiode auf. In einigen Varianten kann das erste LED-Modul 10 wenigstens eine Leuchtdiode für blaues Licht und das zweite LED-Modul 20 wenigstens eine Leuchtdiode für gelbes Licht aufweisen, sodass vorteilhaft durch Mischung der Lichtfarben von blauem und gelbem Licht - also insbesondere von bereits nur zwei Farbkanälen - eine weiße Lichtfarbe erzielt werden kann und/oder der Farbton über das Mischungsverhältnis, insbesondere zwischen warm-weiß und kaltweiß, angepasst werden kann. Um insbesondere eine unterschiedliche Leuchtstärke von unterschiedlichen LEDs, etwa mit unterschiedlichen Farben, auszugleichen, können die LED-Module vorteilhaft in einigen Varianten eine unterschiedliche Anzahl und/oder eine für ein jeweils wiederzugebendes Farbspektrum angepasste Kombination an Leuchtdioden aufweisen. Zudem weist das erste LED-Modul 10 einen ersten Stromanschluss 12 und einen zweiten Stromanschluss 14 auf, welche mit der wenigstens einen Leuchtdiode zur Stromversorgung von dieser elektrisch verbunden sind. Entsprechend weist das zweite LED-Modul einen ersten Stromanschluss 22 und einen Stromanschluss 24 auf, die zur Stromversorgung der wenigstens einen Leuchtdiode des zweiten LED-Moduls 20 mit dieser elektrisch verbunden sind.

Die Betriebsvorrichtung 100 weist zwei Versorgungskanäle 110, 120 zur Versorgung der beiden LED-Module 10, 20 auf. Dabei weist einer der Versorgungskanäle 110 - auch erster Versorgungskanal oder der wenigstens eine der Versorgungskanäle genannt - einen Versorgungsanschluss 112 zur Versorgung eines der LED-Module mit Strom sowie einen Regelungsanschluss 114 - insbesondere für das Ausbilden einer Regelungsschleife zur Regelung des dem LED-Modul zugeführten Stroms bzw. der Energie - auf. Entsprechend weist ein anderer der Versorgungskanäle 120 - auch zweiter Versorgungskanal oder der andere der Versorgungskanäle genannt - einen Versorgungsanschluss 122 sowie einen Regelungsanschluss 124 auf.

In einigen Varianten kann vorteilhaft die den LED-Modulen zugeführte elektrische Leistung über den durch sie fließenden Strom gesteuert, d.h. geregelt werden. Dazu wird über die Versorgungsanschlüsse 112, 122 ein elektrischer Strom ausgegeben und dieser vorzugsweise direkt oder über die dort anliegende Spannung gesteuert. Zudem kann zur vorteilhaften Erfassung des durch das jeweilige LED-Modul fließenden Stroms die Betriebsvorrichtung 100 je Versorgungskanal, d.h. je Regelungsanschluss 114, 124 jeweils einen Shunt-Widerstand 116, 126 aufweisen, sodass der elektrische Strom, welcher von einem der LED-Module in den Regelungsanschluss 114 fließt, über den Shunt-Widerstand 116 eine elektrische Spannung bewirkt, welche zur Bestimmung des elektrischen Stroms, d.h. seiner Stromstärke erfasst werden kann, wobei Entsprechendes für den Regelungsanschluss 124 und den Shunt-Widerstand 126 gilt.

Dabei ist in Fig. 1 eine ordnungsgemäße elektrische Verbindung zwischen der Betriebseinrichtung 100 und den LED-Modulen 10, 20 dargestellt. Dabei ist das erste LED-Modul 10 mit dem ersten Versorgungsanschluss 112 über den Stromanschluss 12 des ersten LED-Moduls elektrisch verbunden und der zweite Stromanschluss 14 des ersten LED-Moduls 10 mit dem Regelungsanschluss 114, also damit auch des ersten Versorgungskanals 110 verbunden. Ebenso ist der erste Stromanschluss 22 des zweiten LED-Moduls 20 mit dem Versorgungsanschluss 122 des zweiten Versorgungskanals 120 verbunden und der zweite Stromanschluss 24 des zweiten LED-Moduls mit dem ersten Regelungsanschluss 124 des zweiten Versorgungskanals 120. Hierdurch bewirkt der von dem ersten Versorgungsanschluss 112 über das erste LED-Modul 110 fließende Strom die elektrische Spannung am Regelungsanschluss 114 und am Shunt-Widerstand 116. Entsprechend bewirkt der Strom, welcher vom zweiten Versorgungsanschluss 122 des zweiten Versorgungskanals über das zweite LED-Modul 20 in den Regelungsanschluss 124 des zweiten Versorgungskanals 120 fließt, eine elektrische Spannung am Shunt-Widerstand 126. Somit lässt sich für den ersten Versorgungskanal 110 und für den zweiten Versorgungskanal 120 eine Regelungsschleife zur Regelung des jeweils fließenden Stroms ausbilden.

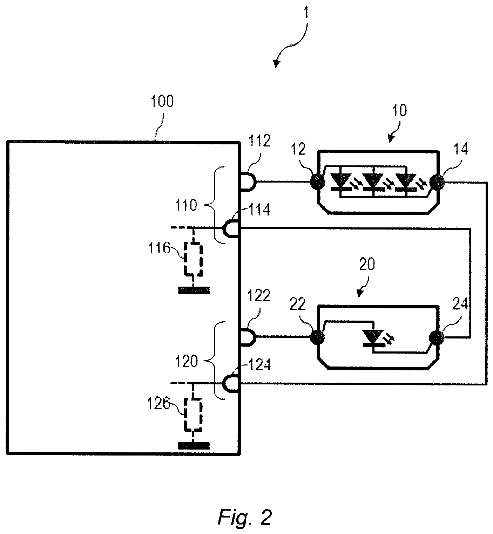

Hingegen verdeutlicht Fig. 2 ein Mehrkanal-LED-System 1 - insbesondere entsprechend dem Mehrkanal-LED-System aus Fig. 1 - mit nicht ordnungsgemäß bzw. fehlerhaft verbundenen LED-Modulen. Dabei ist in einem Ausführungsbeispiel das erste LED-Modul 10 zwar mit dem ersten Versorgungsanschluss 112 der Betriebsvorrichtung 100 über den Stromanschluss 12 des ersten LED-Moduls elektrisch verbunden, aber der zweite Stromanschluss 14 des ersten LED-Moduls ist mit dem Regelungsanschluss 124, also damit des zweiten Versorgungskanals 120 verbunden. Auch ist der erste Stromanschluss 22 des zweiten LED-Moduls 20 mit dem Versorgungsanschluss 122 des zweiten Versorgungskanals 120 verbunden, jedoch der zweite Stromanschluss 24 des zweiten LED-Moduls mit dem ersten Regelungsanschluss 114 des ersten Versorgungskanals 110. Demnach können Regelungsschleifen zur Steuerung des jeweils in die LED-Module abgegebenen Stroms - zumindest bei einem im Stand der Technik üblichen Mehrkanal-Beleuchtungssystem - nicht ausgebildet werden und der abgegebene Strom bzw. die abgegebene elektrische Leistung wird fehlerhaft gesteuert. Dies kann insbesondere zur Zerstörung der LED-Module oder zu einer fehlerhaften Wiedergabe der gewünschten Lichtfarbe führen. Entsprechend besteht Bedarf derartige falsche Verbindungen, d.h. deren Vorliegen zumindest zu bestimmen und vorteilhaft in einigen Ausführungsformen, Ausführungsbeispielen und Varianten, insbesondere der Mehrkanal-LED-Treibervorrichtung, geeignete Gegenmaßnahmen zu ergreifen.

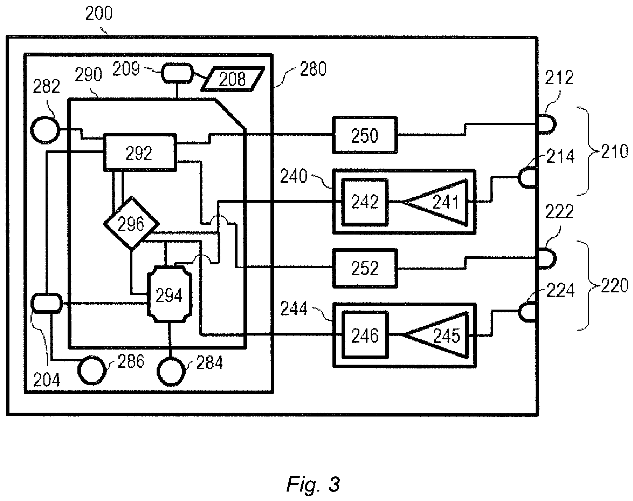

Fig. 3 zeigt schematisch eine Mehrkanal-LED-Treibervorrichtung 200 zur Stromversorgung mehrerer LED-Module nach einer Ausführungsform der vorliegenden Erfindung. In einigen Varianten kann dabei eine solche Mehrkanal-LED-Treibervorrichtung 200 ein Bestandteil eines Mehrkanal-LED-Systems gemäß der Figuren 1 oder 2 sein.

In einem Ausführungsbeispiel weist die Mehrkanal-LED-Treibervorrichtung 200 wenigstens zwei Versorgungskanäle 210, 220 je für ein LED-Modul sowie jeweils einem Stromausgang 212, 222 und einem Messeingang 214, 224 auf, welche jeweils einem der Versorgungskanäle zugeordnet sind. Zudem weist die Mehrkanal-LED-Treibervorrichtung 200 eine Ansteuerungseinrichtung 280 auf, die eingerichtet ist, je Versorgungskanal 210, 220 jeweils wenigstens einen elektrischen Parameter am Stromausgang 212, 222 - insbesondere den am jeweiligen Stromausgang abgegebenen elektrischen Strom - abhängig von einer jeweiligen Eingangsgröße, die mit einem elektrischen Parameter am Messeingang 214, 224 des jeweiligen Versorgungskanals 210, 220 - insbesondere einer elektrischen Spannung - korrespondiert, zu steuern. Außerdem ist die Ansteuerungseinrichtung 280 eingerichtet, wenigstens für einen der Versorgungskanäle 210 zu bestimmen, ob bei Ansteuerung des Stromausgangs 212 dieses Versorgungskanals 210 bei der Eingangsgröße bezüglich dieses Versorgungskanals ein entsprechendes Antwortsignal ausbleibt oder ob die Eingangsgröße bezüglich eines anderen Versorgungskanals 220 einem Antwortsignal entspricht, und, falls wenigstens eines davon der Fall ist, ein Fehlersignal bereitzustellen. Vorteilhaft kann die Ansteuerungseinrichtung 280 auch eingerichtet sein, für den anderen Versorgungskanal 220 Entsprechendes zu bestimmen und auch für diesen ein entsprechendes Fehlersignal bereitzustellen. Auch können einige Varianten eine Fehlersignalausgabeeinrichtung 204 aufweisen, sodass ein entsprechendes Fehlersignal - welches vorzugsweise kennzeichnet, worauf sich dieses bezieht - für die weitere interne Verwendung oder auch für diese externe Verwendung etwa zur Fehlerdiagnose - ausgegeben werden kann.

In einigen vorteilhaften Varianten weist die Ansteuerungseinrichtung 280 einen Mikrocontroller 290 sowie je Versorgungskanal 210, 220 eine Steuerungskomponente 250, 252 für die Stromausgänge 212, 222 zum Steuern des über die Stromausgänge jeweils abgegebenen elektrischen Stroms auf. Vorteilhaft können dabei die Steuerungskomponenten 250, 252 als Abwärtswandler, insbesondere als sogenannter Buck-Converter ausgebildet sein, wobei diese eingerichtet sind, den jeweils abgegebene Strom insbesondere dadurch zu steuern, insbesondere zu begrenzen, dass sie die an ihrem jeweiligen Ausgang anliegende Spannung, insbesondere gegenüber ihrer eigenen Betriebsspannung, reduzieren. Dabei ist der Ausgang der Steuerungskomponente 250 mit dem Stromausgang 212 elektrisch verbunden und entsprechend der Ausgang der Steuerungskomponente 252 mit dem Stromausgang 222. Außerdem weist die Mehrkanal-LED-Treibervorrichtung 200 je Versorgungskanal eine Analog-Digital-Wandler-Einrichtung 240, 244 auf. Die Analog-Digital-Wandler-Einrichtungen weisen je einen Analog-Eingang und einen Digital-Ausgang auf, wobei der Eingang der Analog-Digital-Wandler-Einrichtung 240 mit dem Messeingang 214 elektrisch verbunden ist und der Digital-Ausgang der Analog-Digital-Wandler-Einrichtung 240 mit dem Mikroprozessor 290 datenverbunden ist und entsprechend der Analog-Eingang der Analog-Digital-Wandler-Einrichtung 244 mit dem Messeingang 224 elektrisch verbunden sowie der Digital-Ausgang der Analog-Digital-Wandler-Einrichtung 244 mit dem Mikrocontroller 290 datenverbunden ist. Vorteilhaft können die Analog-Digital-Wandler-Einrichtungen 240, 244 zur Umwandlung der jeweiligen analogen Eingangsgröße - d.h. insbesondere der an den Messeingängen 214, 224 anliegenden elektrischen Spannung - in ein Digital-Signal einen Delta-Sigma-Wandler 242, 246 aufweisen. Auch können in einigen vorteilhaften Varianten die Analog-Digital-Wandler-Einrichtungen 240, 244 zudem je einen Vorverstärker 241, 245 aufweisen, der jeweils eingerichtet ist, das Eingangssignal vor der Wandlung zu verstärken oder zu stützen. In einigen alternativen und vorteilhaften Varianten können auch zwei oder mehr als zwei der Analog-Digital-Wandler-Einrichtungen zu einer entsprechenden Mehrkanal-Wandler-Einrichtung zusammengefasst sein. Schließlich ist der Mikrocontroller 290 auch mit den Steuerungskomponenten 250, 252 datenverbunden und mittels computerlesbarer Anweisungen eingerichtet, auf Basis der über die Analog-Digital-Wandler-Einrichtungen 240, 244 erfassten Eingangsgrößen bezüglich der Messeingänge 214, 224 die Steuerungskomponenten 250, 252 so anzusteuern, dass der bei der Steuerungskomponente 250 bzw. 252 abgegebene Strom von der jeweiligen Eingangsgröße abhängig ist und insbesondere - d.h. bei ordnungsgemäßen elektrischen Verbindungen - geregelt wird und andernfalls ein Fehlersignal bereitgestellt, insbesondere an bzw. mittels der Fehlersignalausgabeeinrichtung 204 ausgegeben wird. Dabei ist der Mikrocontroller 290 insbesondere eingerichtet, die Steuerungskomponenten 250, 252 auf Basis von Konfigurationsdaten zu steuern.

In einigen vorteilhaften Varianten ist der Mikrocontroller 290 eingerichtet, die Messeingänge 214, 224 und die Stromausgänge 212, 222 auf Basis von Konfigurationsdaten zuzuordnen. Auf diese vorteilhafte Weise lässt sich bei einer fehlerhaften elektrischen Verbindung aufgrund von einer fehlerhaften physischen Zuordnung - also insbesondere fehlerhaften elektrischen Verbindung - von Anschlüssen der LED-Module und der Mehrkanal-LED-Treibervorrichtung - wie sie etwa in Fig. 2 verdeutlicht ist - durch eine angepasste Konfiguration beheben. Für die Konfigurationsdaten weist die Mehrkanal-LED-Treibervorrichtung 200 eine persistente Speichereinrichtung 208 sowie eine Datenschnittstelle 209 auf, sodass Konfigurationsdaten mittels der Datenschnittstelle 209 - insbesondere von dem Mikrocontroller 290, welcher die neue Konfiguration bestimmt - empfangen und in der persistenten Speichereinrichtung 208 gespeichert werden können. Dabei kann der Mikrocontroller 290 die Daten, insbesondere über die Datenschnittstelle 209, auch von der Speichereinrichtung 208 wieder abrufen, um diese für die Zuordnung der Stromausgänge 212, 222 und der Messeingänge 214, 224 - insbesondere bei der Steuerung - zu verwenden. Vorteilhaft kann in einigen Varianten die Datenschnittstelle 209 auch so ausgebildet sein, dass diese - etwa zu Diagnosezwecken - extern ausgelesen werden. Für die Zuordnung kann der Mikrocontroller 290 eine Zuordnungskomponente 296 aufweisen, welche als Programmcode oder als elektrische Schaltkreise ausgebildet sein kann und welche eingerichtet ist, die Messeingänge und die Stromausgänge entsprechend der Konfigurationsdaten zuzuordnen und dazu insbesondere die von den Messeingängen empfangenen Eingangsgrößen entsprechend der Konfigurationsdaten anderen Messeingängen für die weitere Verarbeitung zuzuordnen und/oder alternativ jeweils Steuersignale zur Ansteuerung einer der Steuerungskomponenten entsprechend der Konfigurationsdaten einer anderen zuzuordnen.

Zur Ansteuerung der Steuerungskomponenten 250, 252 weist der Mikrocontroller 290 eine Ansteuerungskomponente 292 auf, welche als Programmcode oder als elektrische Schaltkreise ausgebildet sein kann. Auch weist der Mikrocontroller 290 eine Komparator-Komponente 294 auf, welche als Programmcode oder als elektrische Schaltkreise ausgebildet sein kann, wobei der Mikrocontroller 290 mittels dieser Komparator-Komponente 294 eingerichtet ist, zu bestimmen, ob ein entsprechendes Antwortsignal auf eine Stromausgabe an einem der Stromausgänge anliegt oder ausbleibt.

Insbesondere kann die Komparator-Komponente 294 dabei eingerichtet sein, für eine Stromausgabe beim Stromausgang 212 zu überprüfen, ob die über den Messeingang 214 erfasste elektrische Spannung zwischen einem unteren und einem oberen Grenzwert liegt, wobei das Ausbleiben des entsprechenden Antwortsignals beim Messeingang 214 dann bestimmt wird, wenn die erfasste Spannung nicht innerhalb dieser Grenzen, also außerhalb liegt. (Dies kann insbesondere, wie in Fig. 2 dargestellt dann der Fall sein, wenn der Stromausgang 212 über das LED-Modul mit dem Messeingang 224 verbunden ist.) Umgekehrt ist die Komparator-Komponente 294 eingerichtet, das Vorliegen eines entsprechenden Antwortsignals bei einem anderen Messeingang, also insbesondere dem Messeingang 224 dann zu bestimmen, wenn der Absolutbetrag der Eingangsgröße bezüglich dieses anderen Messeingangs, also insbesondere die absolute elektrische Spannung oberhalb eines oberen Grenzwerts liegt. (Dies kann insbesondere dann der Fall sein, wenn wie in Fig. 2 dargestellt, die LED-Module entsprechend falsch angeschlossen sind und, da bei Stromausgabe auf das erste LED-Module keine entsprechende Spannung am Messeingang erzielt wird, der Strom, welcher an das jeweilige LED-Modul ausgegeben wird, bis zu einem maximalen Stromwert aufgrund der fehlerhaften Regelung erhöht wird.) Dabei ist der Mikrocontroller 290 eingerichtet, in wenigstens einem von diesen, vorzugsweise in beiden Fällen das Fehlersignal bereitzustellen.

Umgekehrt kann der Mikrocontroller 290 zusammen mit der Komparator-Komponente 294 vorzugsweise auch entsprechend für den zweiten Versorgungskanal mit dem Stromausgang 222 und dem Messeingang 224 eingerichtet sein.

In einigen vorteilhaften Varianten ist die Ansteuerungseinrichtung 280 bzw. der Mikrocontroller 290 eingerichtet, das Fehlersignal erst nach einer vorbestimmten Zeit auszugeben, d.h. erst dann auszugeben, wenn das Ausbleiben bzw. Entsprechen des Antwortsignals bereits für eine vorbestimmte Zeit vorliegt. Dazu kann die Ansteuerungseinrichtung 280 oder der Mikrocontroller 290 einen Zeitgeber für das Fehlersignal 286 aufweisen, welcher als elektrischer Schaltkreis oder als Programmcode - insbesondere durch Zählen der Taktzyklen des Mikrocontrollers bei der Laufzeit oder Programmierung - ausgebildet sein kann.

In einigen vorteilhaften Varianten kann die Komparator-Komponente 294 eingerichtet sein, das Ausbleiben des entsprechenden Antwortsignals bzw. das Vorliegen des entsprechenden Antwortsignals abhängig davon zu bestimmen, dass die jeweilige Eingangsgröße für eine vorbestimmte Zeit zwischen den Grenzwerten bzw. oberhalb des oberen Grenzwerts liegt. Auf diese vorteilhafte Weise lässt sich eine fehlerhafte Bestimmung - etwa aufgrund von kurzeitigen Störungen - vermeiden. Insbesondere kann dazu die Einstellungseinrichtung 280 oder der Mikrocontroller 290 einen Zeitgeber 284 für den Vergleich mit den Antwortsignalen aufweisen, welcher wiederum als elektrischer Schaltkreis oder als Programmcode ausgebildet sein kann.

Um insbesondere die Antworten auf eine Ansteuerung der jeweiligen Steuerungskomponenten 250, 252 unterscheiden zu können, kann in einigen vorteilhaften Varianten die Ansteuerungseinrichtung 280 oder der Mikrocontroller 290 einen Zeitgeber 282 für die Ansteuerung aufweisen, wobei die Ansteuerungskomponente 292 eingerichtet ist, die Steuerungskomponenten 250, 252 zeitversetzt anzusteuern, sodass eine Antwort, welche bei einem der Messeingänge vorliegt, dem jeweils zu diesem Zeitpunkt angesteuerten Stromausgang 212, 222, d.h. der jeweiligen Steuerungskomponente 250, 252 zugeordnet werden kann.

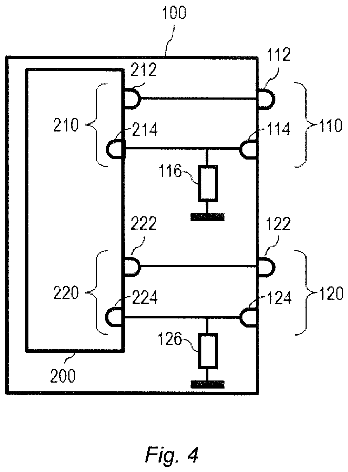

In Fig. 4 ist schematisch eine Betriebsvorrichtung 100 zum Betreiben mehrerer LED-Module nach einer Ausführungsform der vorliegenden Erfindung dargestellt.

In einem Ausführungsbeispiel weist die Betriebsvorrichtung 100 eine Mehrkanal-LED-Treibervorrichtung nach einer Ausführungsform der vorliegenden Erfindung, insbesondere eine Mehrkanal-LED-Treibervorrichtung 200 nach einem Ausführungsbeispiel bezüglich Fig. 3 auf.

Zudem weist die Betriebsvorrichtung 100 nach einem Ausführungsbeispiel mehrere Versorgungskanäle 110, 120 mit je einem Versorgungs- und einem Regelungsanschluss 112, 114 bzw. 122, 124 jeweils für eines der LED-Module und je Regelungsanschluss 112, 114 einen Shunt-Widerstand 116, 126 auf.

Der Versorgungsanschluss 112 ist mit dem entsprechenden Stromausgang 212 der Mehrkanal-LED-Treibervorrichtung 200 elektrisch verbunden und der Versorgungsanschluss 122 mit dem Stromausgang 222. Dabei versteht es sich, dass bei weiteren Versorgungskanälen entsprechende Versorgungsanschlüsse und Stromausgänge entsprechend miteinander verbunden sind.

Auch ist der Shunt-Widerstand 116 mit dem Regelungsanschluss 114 sowie am gleichen Knotenpunkt mit dem Messeingang 214 der Mehrkanal-LED-Treibervorrichtung 200 elektrisch verbunden, wobei Entsprechendes für den Shunt-Widerstand 126, den Regelungsanschluss 124 und den Messeingang 224 der Mehrkanal-LED-Treibereinrichtung 200 und gegebenenfalls Entsprechendes für weitere Versorgungskanäle gilt. Mittels dieser jeweiligen elektrischen Verbindung hängt die am jeweiligen Knotenpunkt anliegende elektrische Spannung von dem Strom, welcher in den jeweiligen Regelungsanschluss 114, 124 fließt, ab. Bei einem ohmschen Widerstand besteht hierbei insbesondere eine lineare Abhängigkeit. Auf diese Weise lässt sich als elektrischer Parameter am jeweiligen Messeingang 214, 224 des jeweiligen Versorgungskanals 210, 220 eine elektrische Spannung, d.h. die dort am Knotenpunkt anliegende elektrische Spannung erfassen und insbesondere zur Steuerung des am jeweils zugeordneten Stromausgang ausgegebenen Stroms verwenden.

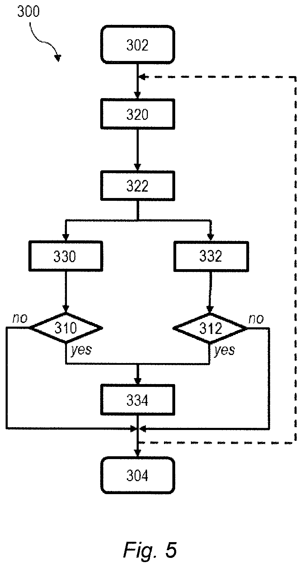

In Fig. 5 ist ein Flussdiagramm eines Verfahrens 300 zum Betreiben einer Mehrkanal-LED-Treibervorrichtung nach einer Ausführungsform der vorliegenden Erfindung dargestellt.

In einem Ausführungsbeispiel weist das Verfahren 300 die Verfahrensschritte 320, 322, 330, 332 und 334 auf. Das Verfahren 300 beginnt bei dem Verfahrensstart 302 und endet bei dem Verfahrensende 304, wobei einer oder mehrere Verfahrensschritte, insbesondere eine Sequenz von Verfahrensschritten, und vorzugsweise das gesamte Verfahren wiederholt ausgeführt werden können.

In einem Ausführungsbeispiel weist die Mehrkanal-LED-Treibervorrichtung, welche mittels dem Verfahren 300 betrieben wird, mehrere Versorgungskanäle je mit einem Stromausgang und einem Messeingang auf und kann in einigen Varianten vorteilhaft nach einer Ausführungsform der vorliegenden Erfindung und/oder nach einem Ausführungsbeispiel bezüglich Fig. 3 ausgebildet sein.

Im Verfahrensschritt 320 wird je Versorgungskanal eine Eingangsgröße, welche mit einem elektrischen Parameter am Messeingang des jeweiligen Versorgungskanals korrespondiert, erfasst.

Im Verfahrensschritt 322 wird ein Steuerungsmittel so angesteuert, dass ein elektrischer Parameter am Stromausgang des jeweiligen Versorgungskanals abhängig von der jeweiligen Eingangsgröße gesteuert wird. In einigen Varianten kann dieser elektrische Parameter am Stromausgang, insbesondere der ausgegebene Strom oder eine dort anliegende elektrische Spannung sein.

Im Verfahrensschritt 330 wird für wenigstens einen der Versorgungskanäle bestimmt, ob bei Ansteuerung des Stromausgangs dieses Versorgungskanals bei der Eingangsgröße bezüglich dieses Versorgungskanals ein entsprechendes Antwortsignal ausbleibt. Auf diese vorteilhafte Weise lässt sich bestimmen, ob in einem Mehrkanal-LED-System mit einer Mehrkanal-LED-Treibervorrichtung, welche mit dem Verfahren 300 betrieben wird, ein LED-Modul für diesen Versorgungskanal nicht ordnungsgemäß elektrisch angeschlossen ist.

Im Verfahrensschritt 332 wird für den wenigstens einen Versorgungskanal bestimmt, ob die Eingangsgröße bezüglich eines anderen Versorgungskanals einem Antwortsignal entspricht. Auch auf diese Weise lässt sich feststellen, ob das LED-Modul, welches mit dem wenigstens einen Versorgungskanal verbunden werden sollte, nicht ordnungsgemäß, sondern - in diesem Fall - zumindest teilweise mit einem anderen Versorgungskanal elektrisch verbunden ist.

Vorteilhaft können dabei die Verfahrensschritte 330 und 332 kombiniert, d.h. beide ausgeführt werden, wobei in anderen Varianten auch nur einer der beiden Verfahrensschritte ausgeführt werden kann, um insbesondere eine fehlerhafte elektrische Verbindung zu bestimmen.

Auch kann vorteilhaft ein dem Verfahrensschritt 330 bzw. dem Verfahrensschritt 332 entsprechender Verfahrensschritt für weitere Versorgungskanäle, vorzugsweise für alle Versorgungskanäle ausgeführt werden.

Im Verfahrensschritt 334 wird ein Fehlersignal bereitgestellt, also der Verfahrensschritt 334 ausgeführt, sofern gemäß einer Verfahrensbedingung 310 das Antwortsignal beim Messeingang des wenigstens einen Versorgungskanals ausbleibt oder gemäß einer Verfahrensbedingung 312 bei dem anderen Versorgungskanal die Eingangsgröße dem Antwortsignal entspricht.

Nach dem Verfahrensschritt 334 oder nach den Verfahrensschritten 330 und/oder 332, sofern der Verfahrensschritt 334 nicht ausgeführt worden ist, da weder die Verfahrensbedingung 310 noch die Verfahrensbedingung 312 (sofern beides überprüft wird) vorgelegen haben, wird das Verfahren beendet 304 oder es kann erneut und/oder wiederholt ausgeführt werden.

In einigen vorteilhaften Varianten wird das Verfahren 300 bei jeder Änderung der elektrischen Verbindungen, insbesondere bei der Herstellung oder Montage eines entsprechenden Mehrkanal-LED-Systems oder einem Anschließen oder Entfernen eines LED-Moduls - etwa zur Installation neuer LED-Module -, erneut ausgeführt. Auch kann das Verfahren vorteilhaft bei jeder Inbetriebnahme eines entsprechenden Mehrkanal-LED-Systems ausgeführt werden, sodass sich bei jeder Inbetriebnahme eine ordnungsgemäße elektrische Verbindung der LED-Module überprüfen lässt. Auch kann das Verfahren im laufenden Betrieb wiederholt - insbesondere in vorbestimmten Zeitintervallen - ausgeführt werden, um auch während des Betriebs auf etwaige Änderungen der elektrischen Verbindungen geeignet reagieren zu können.

Während Ausführungsbeispiele insbesondere unter Bezugnahme auf die Figuren, detailliert beschrieben wurden, sei darauf hingewiesen, dass eine Vielzahl von Abwandlungen möglich ist. Außerdem sei darauf hingewiesen, dass es sich bei den exemplarischen Ausführungen lediglich um Beispiele handelt, die den Schutzbereich, die Anwendung und den Aufbau in keiner Weise einschränken sollen. Vielmehr wird dem Fachmann durch die vorausgehende Beschreibung ein Leitfaden für die Umsetzung von mindestens einem Ausführungsbeispiel gegeben, wobei diverse Abwandlungen, insbesondere alternative oder zusätzliche Merkmale und/oder Abwandlungen der Funktion und/oder Anordnung der beschriebenen Bestandteile, nach Wunsch des Fachmanns vorgenommen werden können, ohne dass dabei von dem in den angehängten Ansprüchen jeweils festgelegten Gegenstand sowie seiner rechtlichen Äquivalenten abgewichen wird und/oder deren Schutzbereich verlassen wird.

### BEZUGSZEICHENLISTE

- 1: Mehrkanal-LED-System
- 10: Erstes LED-Modul
- 12: Erster Stromanschluss des ersten LED-Moduls
- 14: Zweiter Stromanschluss des ersten LED-Moduls
- 20: Zweites LED-Modul
- 22: Erster Stromanschluss des zweiten LED-Moduls
- 24: Zweiter Stromanschluss des zweiten LED-Moduls
- 100: Betriebsvorrichtung zum Betreiben mehrerer LED-Module
- 110, 120: Versorgungskanäle der Betriebsvorrichtung
- 112, 122: Versorgungsanschlüsse der Betriebsvorrichtung
- 114, 124: Regelungsanschlüsse der Betriebsvorrichtung
- 116, 126: Shunt-Widerstände
- 200: Mehrkanal-LED-Treibervorrichtung
- 204: Fehlersignalausgabeeinrichtung
- 208: Persistente Speichereinrichtung
- 209: Datenschnittstelle
- 210, 220: Versorgungskanäle der Mehrkanal-LED-Treibervorrichtung
- 212, 222: Stromausgänge der Mehrkanal-LED-Treibervorrichtung
- 214, 224: Messeingänge der Mehrkanal-LED-Treibervorrichtung
- 240, 244: Analog-Digital-Wandler-Einrichtung
- 241, 245: Vorverstärker
- 242, 246: Delta-Sigma-Analog-Digital-Umsetzer
- 250,252: Steuerungskomponente
- 280: Ansteuerungseinrichtung
- 282: Zeitgeber für Ansteuerung
- 284: Zeitgeber für Antwortsignal
- 286: Zeitgeber für Fehlersignal
- 290: Mikrocontroller
- 292: Ansteuerungskomponente
- 294: Komparatorkomponente
- 296: Zuordnungskomponente
- 300: Verfahren zum Betreiben einer Mehrkanal-LED-Treibervorrichtung
- 302: Verfahrensstart
- 304: Verfahrensende
- 310: Verfahrensbedingung: Ausbleiben von Antwortsignal
- 312: Verfahrensbedingung: Entsprechen von Antwortsignal
- 320: Verfahrensschritt: Erfassen Eingangsgröße
- 322: Verfahrensschritt: Ansteuern Steuerungsmittels
- 330: Verfahrensschritt: Bestimmen Ausbleiben von Antwortsignal
- 332: Verfahrensschritt: Bestimmen Entsprechen von Antwortsignal
- 334: Verfahrensschritt: Bereitstellen Fehlersignal

## Patentansprüche

1. Mehrkanal-LED-Treibervorrichtung (200) zur Stromversorgung mehrerer LED-Module, aufweisend:
wenigstens zwei Versorgungskanäle (210; 220) je für ein LED-Modul, wobei die wenigstens zwei Versorgungskanäle (210; 220) jeweils einen Stromausgang (212; 222) und jeweils einen Messeingang (214; 224) aufweisen; wobei jedes LED-Modul der mehreren LED-Module einen ersten Stromanschluss (12; 22), welcher mit dem Stromausgang (212; 222) eines der wenigstens zwei Versorgungskanäle (210; 220) verbindbar ist, und einen zweiten Stromanschluss (14; 24), welcher mit dem Messeingang (214; 224) eines der wenigstens zwei Versorgungskanäle (210; 220) verbindbar ist, aufweist, und
eine Ansteuerungseinrichtung (280), die eingerichtet ist, einen jeweiligen elektrischen Parameter an dem jeweiligen Messeingang (214; 224) des jeweiligen Versorgungskanals (210; 220) zu erfassen und je Versorgungskanal (210; 220) der wenigstens zwei Versorgungskanäle (210; 220) jeweils wenigstens einen der jeweiligen elektrischen Parameter am jeweiligen Stromausgang (212; 222) abhängig von einer jeweiligen Eingangsgröße, die mit dem jeweiligen elektrischen Parameter am jeweiligen Messeingang (214; 224) des jeweiligen Versorgungskanals (210; 220) korrespondiert, zu steuern;
**dadurch gekennzeichnet, dass**
die Ansteuerungseinrichtung (280) zudem eingerichtet ist, basierend auf Konfigurationsdaten die jeweiligen Stromausgänge (212; 222) und die jeweiligen Messeingänge (214; 224) zuzuordnen und mittels einer Komparatorkomponente (294) der Ansteuerungseinrichtung (280) wenigstens für einen der wenigstens zwei Versorgungskanäle (210; 220) zu bestimmen, ob bei Ansteuerung des jeweiligen zugeordneten Stromausgangs (212) dieses wenigstens einen Versorgungskanals (210) bei der Eingangsgröße dieses wenigstens einen Versorgungskanals ein entsprechendes Antwortsignal an dem jeweiligen zugeordneten Messeingang dieses wenigstens einen Versorgungskanals ausbleibt oder ob bei Ansteuerung des jeweilig zugeordneten Stromausgang dieses wenigsten einen Versorgungskanals (210) bei der Eingangsgröße an dem zugeordneten Messeingang eines anderen Versorgungskanals (220) der wenigstens zwei Versorgungskanäle (210; 220) einem Antwortsignal entspricht, und ein Fehlersignal bereitzustellen, wenn das Antwortsignal beim Messeingang des wenigstens einen Versorgungskanals ausbleibt oder bei dem Messeingang des anderen Versorgungskanal die Eingangsgröße dem Antwortsignal entspricht.

2. Mehrkanal-LED-Treibervorrichtung (200) gemäß Anspruch 1, wobei die Ansteuerungseinrichtung (280) eingerichtet ist, diesen wenigstens einen Versorgungskanal (210) der wenigstens zwei Versorgungskanäle (210; 220) und den anderen Versorgungskanal (220) der wenigstens zwei Versorgungskanäle (210; 220) zeitlich versetzt anzusteuern.

3. Mehrkanal-LED-Treibervorrichtung (200) gemäß Anspruch 1 oder 2, wobei das Fehlersignal erst nach einer vorbestimmten Zeitspanne bereitgestellt wird.

4. Mehrkanal-LED-Treibervorrichtung (200) gemäß einem der vorhergehenden Ansprüche, wobei die Ansteuerungseinrichtung (280) eingerichtet ist, das Ausbleiben des entsprechenden Antwortsignals bei der Eingangsgröße bezüglich dieses wenigstens einen Versorgungskanals (210) zu bestimmen, wobei diese bestimmt, ob diese Eingangsgröße nicht zwischen einem unteren und einem oberen Grenzwert liegt, wobei für das Bestimmen des Ausbleibens des entsprechenden Antwortsignals diese Eingangsgröße vorzugsweise über eine vorbestimmte Zeitspanne nicht zwischen dem unteren und dem oberen Grenzwert liegen darf.

5. Mehrkanal-LED-Treibervorrichtung (200) gemäß einem der vorhergehenden Ansprüche, wobei die Ansteuerungseinrichtung (280) eingerichtet ist, das Entsprechen des Antwortsignals bei der Eingangsgröße bezüglich eines anderen Versorgungskanals (220) der wenigstens zwei Versorgungskanäle (210; 220) zu bestimmen, indem diese bestimmt, ob der Absolutbetrag der Eingangsgröße bezüglich des anderen Versorgungskanals (220) oberhalb eines oberen Grenzwerts liegt, wobei für das Bestimmen des Entsprechens des Antwortsignals der Absolutbetrag der Eingangsgröße bezüglich des anderen Versorgungskanals (220) vorzugsweise über eine vorbestimmte Zeitspanne oberhalb des oberen Grenzwerts liegen muss.

6. Mehrkanal-LED-Treibervorrichtung (200) gemäß einem der vorhergehenden Ansprüche, wobei die Ansteuerungseinrichtung (280) eingerichtet ist, bei Vorliegen des Fehlersignals zumindest den elektrischen Parameter am Stromausgang (212) des Versorgungskanals (210), auf welchen sich das Fehlersignal bezieht, oder jeweils den elektrischen Parameter an den Stromausgängen (212; 222) von allen Versorgungskanälen (210; 220) auf einen vorbestimmten Wert zu stellen.

7. Mehrkanal-LED-Treibervorrichtung (200) gemäß Anspruch 6, wobei der vorbestimmte Wert so vorbestimmt ist, dass kein elektrischer Strom oder keine elektrische Leistung an dem Stromausgang (212) beziehungsweise an den Stromausgängen (212; 222) ausgegeben wird.

8. Mehrkanal-LED-Treibervorrichtung (200) gemäß einem der vorhergehenden Ansprüche,
wobei die Mehrkanal-LED-Treibervorrichtung des Weiteren jeweils eine Analog-Digital-Wandler-Einrichtung (240; 244) zur Wandlung der an den jeweiligen Messeingängen(214; 224) anliegenden Eingangsgrösse und jeweils eine Steuerungskomponente (250; 252) zum Steuern des jeweiligen elektrischen Parameter des jeweiligen Stromausgangs (212; 222) aufweist sowie die Ansteuerungseinrichtung (280) einen Mikrocontroller (290) aufweist; und
wobei der Mikrocontroller (290) mit der jeweiligen Analog-Digital-Wandler-Einrichtung (240; 244) sowie der jeweiligen Steuerungskomponente (250; 252) verbunden ist und mittels computerlesbarer Anweisungen eingerichtet ist, entsprechend der Ansteuerungseinrichtung der Mehrkanal-LED-Treibervorrichtung (200) auf Basis der Eingangsgrößen bezüglich der jeweiligen Messeingänge (214; 224) und der Konfigurationsdaten die jeweilige Steuerungskomponente (250; 252) anzusteuern und das Fehlersignal bereitzustellen.

9. Mehrkanal-LED-Treibervorrichtung (200) gemäß einem der vorhergehenden Ansprüche, wobei der jeweils wenigstens eine elektrische Parameter am Stromausgang (212; 222) eine Stromstärke ist, und wobei der elektrische Parameter am Messeingang (214; 224) des jeweiligen Versorgungskanals (210; 220) eine elektrische Spannung ist.

10. Verfahren (300) zum Betreiben einer Mehrkanal-LED-Treibervorrichtung gemäß einem der vorgehenden Ansprüche 1-9 wobei das Verfahren aufweist:
- Erfassen (320), mittels der Ansteuereinrichtung, des jeweiligen elektrischen Parameters an dem jeweiligen Messeingang (214; 224) des jeweiligen Versorgungskanals (210; 220),
- Ansteuern (322), mittels der Ansteuereinrichtung,des jeweiligen elektrischen Parameters am jeweiligen Stromausgang (212; 222) abhängig von der jeweiligen Eingangsgröße, die mit dem jeweiligen elektrischen Parameter am jeweiligen Messeingang (214; 224) des jeweiligen Versorgungskanals (210; 220) korrespondiert;
- Zuordnen ,mittels der Ansteuereinrichtung, der jeweiligen Stromausgänge (212; 222) und der jeweiligen Messeingänge (214; 224) basierend auf den Konfigurationsdaten;
- Bestimmen (330; 332), mittels einer Komparatorkomponente (294), ob bei Ansteuerung des jeweiligen zugeordneten Stromausgangs (212) dieses wenigstens einen Versorgungskanals (210) bei der Eingangsgröße dieses wenigstens einen Versorgungskanals ein entsprechendes Antwortsignal an dem jeweiligen zugeordneten Messeingang in der Eingangsgröße bezüglich dieses wenigstens einen Versorgungskanals ausbleibt oder ob bei Ansteuerung des jeweilig zugeordneten Stromausgang dieses wenigsten einen Versorgungskanals () bei der Eingangsgröße an dem zugeordneten Messeingang dem anderen Versorgungskanals der wenigstens zwei Versorgungskanäle (210; 220) dem Antwortsignal entspricht; und
- Bereitstellen (334), mittels der Ansteuereinrichtung, des Fehlersignals, wenn das Antwortsignal beim Messeingang des wenigstens einen Versorgungskanals ausbleibt oder bei dem anderen Versorgungskanal die Eingangsgröße dem Antwortsignal entspricht.

11. Betriebsvorrichtung (100) zum Betreiben mehrerer LED-Module, aufweisend wenigstens zwei Versorgungskanäle (110; 120) mit je einem Versorgungs- und einem Regelungsanschluss (112, 114; 122, 124) eine Mehrkanal-LED-Treibervorrichtung (200) gemäß einem der Ansprüche 1 bis 9 und je Regelungsanschluss (114; 124) einen Knotenpunkt und einen Shunt-Widerstand (116; 126), wobei
der erste Stromanschluss eines jeden LED-Moduls der mehreren LED-Module mit dem jeweiligen Versorgungsanschluss der wenigstens zwei Versorgungskanäle der Betriebsvorrichtung verbindbar ist, und der zweite Stromanschluss (14; 24), eines jeden LED-Moduls der mehreren LED-Module mit dem jeweiligen Regelanschluss der wenigstens zwei Versorgungskanäle der Betriebsvorrichtung verbindbar ist, wobei jeweils einer der Versorgungsanschlüsse (112; 122) mit einem jeweiligen Stromausgang (212; 222) der Mehrkanal-LED-Treibervorrichtung (200) elektrisch verbunden ist;
wobei der jeweilige elektrische Parameter am Messeingang (214; 224) des jeweiligen Versorgungskanals (210; 220) der Mehrkanal-LED-Treibervorrichtung (200) eine elektrische Spannung ist; und
mittels des jeweiligen Knotenpunkts der jeweilige Shunt-Widerstand (116; 126) mit dem entsprechenden Regelungsanschluss (114; 124) sowie mit dem entsprechenden Messeingang (214; 224) der Mehrkanal-LED-Treibervorrichtung (200) elektrisch verbunden ist, wobei die an dem jeweiligen Knotenpunkt anliegende elektrische Spannung von dem Strom, welcher in dem jeweiligen Regelungsanschluss (114; 124) fließt, abhängig ist.

## Claims

1. Multi-channel LED driver apparatus (200) for supplying current to a plurality of LED modules, comprising:
at least two supply channels (210; 220) each for an LED module, the at least two supply channels (210; 220) each having a current output (212; 222) and each having a measurement input (214; 224), each LED module of the plurality of LED modules having a first current connection (12; 22) which can be connected to the current output (212; 222) of one of the at least two supply channels (210; 220), and a second current connection (14; 24) which can be connected to the measurement input (214; 224) of one of the at least two supply channels (210; 220), and
an actuation device (280) which is configured to detect a relevant electrical parameter at the relevant measurement input (214; 224) of the relevant supply channel (210; 220) and to carry out open-loop control of, for each supply channel (210; 220) of the at least two supply channels (210; 220), in each case at least one of the respective electrical parameters at the relevant current output (212; 222) depending on a relevant input quantity, which corresponds to the relevant electrical parameter at the relevant measurement input (214; 224) of the relevant supply channel (210; 220);
**characterized in that**
the actuation device (280) is also configured to assign, based on configuration data, the respective current outputs (212; 222) and the respective measurement inputs (214; 224) and to determine, by means of a comparator component (294) of the actuation device (280), at least for one of the at least two supply channels (210; 220), whether, when the relevant assigned current output (212) of this at least one supply channel (210) is actuated, at the input quantity of this at least one supply channel, a corresponding response signal is absent at the relevant assigned measurement input of this at least one supply channel, or to determine whether, when the relevant assigned current output of this at least one supply channel (210) is actuated, the input quantity at the assigned measurement input of another supply channel (220) of the at least two supply channels (210; 220) corresponds to a response signal, and to provide an error signal if the response signal is absent at the measurement input of the at least one supply channel or the input quantity corresponds to the response signal at the measurement input of the other supply channel.

2. Multi-channel LED driver apparatus (200) according to claim 1, wherein the actuation device (280) is configured to actuate this at least one supply channel (210) of the at least two supply channels (210; 220) and the other supply channel (220) of the at least two supply channels (210; 220) with a time delay.

3. Multi-channel LED driver apparatus (200) according to either claim 1 or claim 2, wherein the error signal is only provided after a predetermined period of time.

4. Multi-channel LED driver apparatus (200) according to any of the preceding claims, wherein the actuation device (280) is configured to determine the absence of the corresponding response signal at the input quantity with respect to this at least one supply channel (210), wherein said device determines whether this input quantity is not between a lower and an upper limit value, wherein, for determining the absence of the corresponding response signal, this input quantity may preferably not be between the lower and the upper limit value over a predetermined period of time.

5. Multi-channel LED driver apparatus (200) according to any of the preceding claims, wherein the actuation device (280) is configured to determine the correspondence of the response signal at the input quantity with respect to another supply channel (220) of the at least two supply channels (210; 220) by determining whether the absolute value of the input quantity with respect to the other supply channel (220) is above an upper limit value, wherein, for determining the correspondence of the response signal, the absolute value of the input quantity with respect to the other supply channel (220) must preferably be above the upper limit value over a predetermined period of time.

6. Multi-channel LED driver apparatus (200) according to any of the preceding claims, wherein, when the fault signal is present, the actuation device (280) is configured to set at least the electrical parameter at the current output (212) of the supply channel (210), to which the fault signal relates, or in each case the electrical parameter at the current outputs (212; 222) of all supply channels (210; 220), to a predetermined value.

7. Multi-channel LED driver apparatus (200) according to claim 6, wherein the predetermined value is predetermined such that no electrical current or no electrical power is output at the current output (212) or at the current outputs (212; 222).

8. Multi-channel LED driver apparatus (200) according to any of the preceding claims,
wherein the multi-channel LED driver apparatus further comprises in each case an analog-to-digital converter device (240; 244) for converting the input quantities applied to the respective measurement inputs (214; 224) and in each case an open-loop control component (250; 252) for controlling the relevant electrical parameter of the relevant current output (212; 222), and the actuation device (280) has a microcontroller (290); and
wherein the microcontroller (290) is connected to the relevant analog-to-digital converter device (240; 244) and to the relevant open-loop control component (250; 252) and is configured by means of computer-readable instructions to actuate the relevant open-loop control component (250; 252) in accordance with the actuation device of the multi-channel LED driver apparatus (200) on the basis of the input quantities with respect to the respective measurement inputs (214; 224) and the configuration data and to provide the error signal.

9. Multi-channel LED driver apparatus (200) according to any of the preceding claims, wherein in each case the at least one electrical parameter at the current output (212; 222) is a current intensity, and wherein the electrical parameter at the measurement input (214; 224) of the relevant supply channel (210; 220) is an electrical voltage.

10. Method (300) for operating a multi-channel LED driver apparatus according to any of the preceding claims 1-9, wherein the method comprises:
- detecting (320), by means of the actuation device, the relevant electrical parameter at the relevant measurement input (214; 224) of the relevant supply channel (210; 220),
- actuating (322), by means of the actuation device, the relevant electrical parameter at the relevant current output (212; 222) depending on the relevant input quantity which corresponds to the relevant electrical parameter at the relevant measurement input (214; 224) of the relevant supply channel (210; 220);
- assigning, by means of the actuation device, the respective current outputs (212; 222) and the respective measurement inputs (214; 224) based on the configuration data;
- determining (330; 332), by means of a comparator component (294), whether, when the relevant assigned current output (212) of this at least one supply channel (210) is actuated, at the input quantity of this at least one supply channel, a corresponding response signal at the relevant assigned measurement input is absent in the input quantity with respect to this at least one supply channel or whether, when the relevant assigned current output of this at least one supply channel is actuated, the input quantity at the assigned measurement input of the other supply channel of the at least two supply channels (210; 220) corresponds to the response signal; and
- providing (334), by means of the actuation device, the error signal if the response signal is absent at the measurement input of the at least one supply channel or the input quantity corresponds to the response signal at the other supply channel.

11. Operating apparatus (100) for operating a plurality of LED modules, comprising at least two supply channels (110; 120) comprising, respectively, a supply and a closed-loop control connection (112, 114; 122, 124), a multi-channel LED driver apparatus (200) according to any of claims 1 to 9, and a node and a shunt resistor (116; 126) per closed-loop control connection (114; 124), wherein
the first current connection of each LED module of the plurality of LED modules can be connected to the relevant supply connection of the at least two supply channels of the operating apparatus, and the second current connection (14; 24), of one of each LED module of the plurality of LED modules can be connected to the relevant control connection of the at least two supply channels of the operating apparatus, wherein in each case one of the supply connections (112; 122) is electrically connected to a relevant current output (212; 222) of the multi-channel LED driver apparatus (200);
wherein the relevant electrical parameter at the measurement input (214; 224) of the relevant supply channel (210; 220) of the multi-channel LED driver apparatus (200) is an electrical voltage; and
by means of the relevant node point, the relevant shunt resistor (116; 126) is electrically connected to the corresponding closed-loop control connection (114; 124) and to the corresponding measurement input (214; 224) of the multi-channel LED driver apparatus (200), wherein the electrical voltage present at the relevant node point is dependent on the current which flows in the relevant closed-loop control connection (114; 124).

## Revendications

1. Dispositif multicanal de pilotage de DEL (200) permettant l'alimentation en courant de plusieurs modules DEL, présentant :
au moins deux canaux d'alimentation (210 ; 220), chacun étant destiné à un module DEL, dans lequel les au moins deux canaux d'alimentation (210 ; 220) présentent respectivement une sortie de courant (212 ; 222) et respectivement une entrée de mesure (214 ; 224) ; dans lequel chaque module DEL des modules DEL présente un premier raccordement au courant (12 ; 22) qui peut être connecté à la sortie de courant (212 ; 222) de l'un des au moins deux canaux d'alimentation (210 ; 220), et un second raccordement au courant (14 ; 24) qui peut être connecté à l'entrée de mesure (214 ; 224) de l'un des au moins deux canaux d'alimentation (210 ; 220), et
un appareil d'activation (280) qui est configuré pour détecter un paramètre électrique respectif à l'entrée de mesure (214 ; 224) respective du canal d'alimentation (210 ; 220) respectif et pour commander, pour chaque canal d'alimentation (210 ; 220) des au moins deux canaux d'alimentation (210 ; 220), respectivement au moins l'un des paramètres électriques respectifs à la sortie de courant (212 ; 222) respective en fonction d'une grandeur d'entrée respective qui correspond au paramètre électrique respectif à l'entrée de mesure (214 ; 224) respective du canal d'alimentation (210 ; 220) respectif ;
**caractérisé en ce que**
l'appareil d'activation (280) est en outre configuré pour associer, sur la base de données de configuration, les sorties de courant (212 ; 222) respectives et les entrées de mesure (214 ; 224) respectives et pour déterminer, au moyen d'un composant comparateur (294) de l'appareil d'activation (280) au moins destiné à l'un des au moins deux canaux d'alimentation (210 ; 220), si, lors de l'activation de la sortie de courant (212) associée respective dudit au moins un canal d'alimentation (210), au niveau de la grandeur d'entrée dudit au moins un canal d'alimentation, un signal de réponse adéquat est absent à l'entrée de mesure associée respective dudit au moins un canal d'alimentation ou si, lors de l'activation de la sortie de courant respectivement associée dudit au moins un canal d'alimentation (210), la grandeur d'entrée à l'entrée de mesure associée d'un autre canal d'alimentation (220) des au moins deux canaux d'alimentation (210 ; 220) est en adéquation avec un signal de réponse, et pour fournir un signal d'erreur lorsque le signal de réponse est absent à l'entrée de mesure de l'au moins un canal d'alimentation ou lorsque la grandeur d'entrée est en adéquation avec le signal de réponse à l'entrée de mesure de l'autre canal d'alimentation.

2. Dispositif multicanal de pilotage de DEL (200) selon la revendication 1, dans lequel l'appareil d'activation (280) est configuré pour activer de manière décalée dans le temps ledit au moins un canal d'alimentation (210) des au moins deux canaux d'alimentation (210 ; 220) et l'autre canal d'alimentation (220) des au moins deux canaux d'alimentation (210 ; 220).

3. Dispositif multicanal de pilotage de DEL (200) selon la revendication 1 ou 2, dans lequel le signal d'erreur n'est fourni qu'après une durée prédéterminée.

4. Dispositif multicanal de pilotage de DEL (200) selon l'une des revendications précédentes, dans lequel l'appareil d'activation (280) est configuré pour déterminer l'absence du signal de réponse adéquat à la grandeur d'entrée relative audit au moins un canal d'alimentation (210), dans lequel ledit appareil d'activation détermine si ladite grandeur d'entrée ne se situe pas entre une valeur limite inférieure et une valeur limite supérieure, dans lequel, pour la détermination de l'absence du signal de réponse adéquat, ladite grandeur d'entrée ne peut de préférence pas se situer entre la valeur limite inférieure et la valeur limite supérieure pendant une durée prédéterminée.

5. Dispositif multicanal de pilotage de DEL (200) selon l'une des revendications précédentes, dans lequel l'appareil d'activation (280) est configuré pour déterminer l'adéquation du signal de réponse avec la grandeur d'entrée relative à un autre canal d'alimentation (220) des au moins deux canaux d'alimentation (210 ; 220) en déterminant si la valeur absolue de la grandeur d'entrée relative à l'autre canal d'alimentation (220) se situe au-dessus d'une valeur limite supérieure, dans lequel, pour la détermination de l'adéquation du signal de réponse, la valeur absolue de la grandeur d'entrée relative à l'autre canal d'alimentation (220) doit de préférence se situer au-dessus de la valeur limite supérieure pendant une durée prédéterminée.

6. Dispositif multicanal de pilotage de DEL (200) selon l'une des revendications précédentes, dans lequel l'appareil d'activation (280) est configuré pour régler, en présence du signal d'erreur, au moins le paramètre électrique à la sortie de courant (212) du canal d'alimentation (210) auquel se rapporte le signal d'erreur, ou respectivement le paramètre électrique aux sorties de courant (212 ; 222) de tous les canaux d'alimentation (210 ; 220), à une valeur prédéterminée.

7. Dispositif multicanal de pilotage de DEL (200) selon la revendication 6, dans lequel la valeur prédéterminée est prédéterminée de manière telle qu'aucun courant électrique ou qu'aucune puissance électrique n'est délivré à la sortie de courant (212) ou aux sorties de courant (212 ; 222).

8. Dispositif multicanal de pilotage de DEL (200) selon l'une des revendications précédentes,
dans lequel le dispositif multicanal de pilotage de DEL présente en outre respectivement un appareil de conversion analogique-numérique (240 ; 244) permettant de convertir les grandeurs d'entrée appliquées aux entrées de mesure (214 ; 224) respectives et respectivement un composant de commande (250 ; 252) permettant de commander le paramètre électrique respectif de la sortie de courant (212 ; 222) respective, et l'appareil d'activation (280) présente un microcontrôleur (290) ; et
dans lequel le microcontrôleur (290) est connecté à l'appareil de conversion analogique-numérique (240 ; 244) respectif ainsi qu'au composant de commande (250 ; 252) respectif et est configuré, au moyen d'instructions lisibles par ordinateur, pour activer le composant de commande (250 ; 252) respectif et pour fournir le signal d'erreur, en adéquation avec l'appareil d'activation du dispositif multicanal de pilotage de DEL (200) sur la base des grandeurs d'entrée relatives aux entrées de mesure (214 ; 224) respectives et des données de configuration.

9. Dispositif multicanal de pilotage de DEL (200) selon l'une des revendications précédentes, dans lequel l'au moins un paramètre électrique respectif à la sortie de courant (212 ; 222) est une intensité de courant, et dans lequel le paramètre électrique à l'entrée de mesure (214 ; 224) du canal d'alimentation (210 ; 220) respectif est une tension électrique.

10. Procédé (300) permettant de faire fonctionner un dispositif multicanal de pilotage de DEL selon l'une des revendications précédentes 1 à 9, dans lequel le procédé présente :
- la détection (320), au moyen de l'appareil d'activation, du paramètre électrique respectif à l'entrée de mesure (214 ; 224) respective du canal d'alimentation (210 ; 220) respectif,
- l'activation (322), au moyen de l'appareil d'activation, du paramètre électrique respectif à la sortie de courant (212 ; 222) respective en fonction de la grandeur d'entrée respective qui correspond au paramètre électrique respectif à l'entrée de mesure (214 ; 224) respective du canal d'alimentation (210 ; 220) respectif ;
- l'association, au moyen de l'appareil d'activation, des sorties de courant (212 ; 222) respectives et des entrées de mesure (214 ; 224) respectives sur la base des données de configuration ;
- la détermination (330 ; 332), au moyen d'un composant comparateur (294), du fait de savoir si, lors de l'activation de la sortie de courant (212) associée respective dudit au moins un canal d'alimentation (210), au niveau de la grandeur d'entrée dudit au moins un canal d'alimentation, un signal de réponse adéquat est absent à l'entrée de mesure associée respective dans la grandeur d'entrée relative audit au moins un canal d'alimentation ou si, lors de l'activation de la sortie de courant associée respective dudit au moins un canal d'alimentation, la grandeur d'entrée à l'entrée de mesure associée de l'autre canal d'alimentation des au moins deux canaux d'alimentation (210 ; 220) est en adéquation avec le signal de réponse ; et
- la fourniture (334), au moyen de l'appareil d'activation, du signal d'erreur lorsque le signal de réponse est absent au niveau de l'entrée de mesure de l'au moins un canal d'alimentation ou lorsque la grandeur d'entrée est en adéquation avec le signal de réponse au niveau de l'autre canal d'alimentation.

11. Dispositif de fonctionnement (100) permettant de faire fonctionner plusieurs modules DEL, présentant au moins deux canaux d'alimentation (110 ; 120) comportant respectivement un raccordement d'alimentation et un raccordement de régulation (112, 114 ; 122, 124), un dispositif multicanal de pilotage de DEL (200) selon l'une des revendications 1 à 9 et, pour chaque raccordement de régulation (114 ; 124), un point nodal et une résistance de shunt (116 ; 126), dans lequel
le premier raccordement au courant de chaque module DEL des modules DEL peut être connecté au raccordement d'alimentation respectif des au moins deux canaux d'alimentation du dispositif de fonctionnement, et le second raccordement au courant (14 ; 24) de chaque module DEL des modules DEL peut être connecté au raccordement de régulation respectif des au moins deux canaux d'alimentation du dispositif de fonctionnement, dans lequel respectivement l'un des raccordements d'alimentation (112 ; 122) est connecté électriquement à une sortie de courant (212 ; 222) respective du dispositif multicanal de pilotage de DEL (200) ;
dans lequel le paramètre électrique respectif à l'entrée de mesure (214 ; 224) du canal d'alimentation (210 ; 220) respectif du dispositif multicanal de pilotage de DEL (200) est une tension électrique ; et
au moyen du point nodal respectif, la résistance de shunt (116 ; 126) respective est connectée électriquement au raccordement de régulation (114 ; 124) adéquat ainsi qu'à l'entrée de mesure (214 ; 224) adéquate du dispositif multicanal de pilotage de DEL (200), dans lequel la tension électrique appliquée au point nodal respectif dépend du courant qui circule dans le raccordement de régulation (114 ; 124) respectif.
